# EUROPEAN PATENT APPLICATION

(11) **EP 4 671 659 A1**
(43) Date of publication of application: **31.12.2025**
(21) Application number: 25184579.8
(22) Date of filing: 23.06.2025
(51) Int. Cl.: F28D 15/02, F28D 9/00, H01L 23/427, H05K 7/20

(54) **HEAT PIPE AND ELECTRONIC DEVICE INCLUDING THE HEAT PIPE**

(30) Priority: 28.06.2024 KR 20240084962
(71) Applicant: Samsung Display Co., Ltd., Yongin-si, Gyeonggi-do 17113 (KR)
(72) Inventor: KIM, Sunghoon, 17113 Yongin-si (KR); KIM, Minki, 17113 Yongin-si (KR); PARK, Haengwon, 17113 Yongin-si (KR); BAE, Hyunchul, 17113 Yongin-si (KR); SON, Junhee, 17113 Yongin-si (KR); HWANG, Sangho, 17113 Yongin-si (KR)
(74) Representative: Walaski, Jan Filip

(57) **Abstract**

A heat pipe includes: a base plate; a capillary on the base plate and including a plurality of patterned portions connected to each other to form a closed loop; and a cover plate on one surface of the base plate and covering the capillary. Each of the plurality of patterned portions includes: a first capillary portion having a first diameter; a second capillary portion having a second diameter smaller than the first diameter; and a turn portion connecting the first capillary portion and the second capillary portion. The number of the turn portions per unit area is the greatest at a central portion of the base plate.

## Description

### BACKGROUND

### 1. Field

The disclosure relates to a heat pipe. More particularly, the disclosure relates to a pulsating heat pipe and an electronic device including the pulsating heat pipe.

### 2. Description of the Related Art

Heat pipes, which do not require external power, are commonly used in cooling systems. They offer advantages such as being noiseless, having high heat transfer efficiency, and being compact. Heat pipes are utilized to cool electronic devices and to enhance the heat absorption of solar collectors.

A wick structure, including (composed of) a porous material and with a set or predetermined thickness, is arranged inside a heat pipe to circulate a working fluid. However, the performance of heat pipes with wicks deteriorates as the thickness of the wick decreases, limiting the implementation of ultra-compact cooling systems.

To address this issue, pulsating heat pipes have been developed. These pipes induce capillary action without using a wick, allowing the working fluid to evaporate, condense, vibrate, and circulate effectively.

The information disclosed in this Background section is intended to enhance understanding of the background of the disclosure and therefore it may contain information that does not constitute prior art.

### SUMMARY

Aspects according to one or more embodiments of the present disclosure are directed toward a heat pipe with improved or enhanced heat dissipation performance.

Aspects according to one or more embodiments of the present disclosure are directed toward an electronic device including the heat pipe.

Additional aspects will be set forth in part in the description which follows and, in part, will be apparent from the description, or may be learned by practice of the presented embodiments of the disclosure.

A heat pipe according to one or more embodiments of the present disclosure includes: a base plate; a capillary on the base plate and including a plurality of patterned portions connected to each other to form a closed loop; and a cover plate arranged on one surface of the base plate and covering the capillary. Each of the plurality of patterned portions includes: a first capillary portion having a first diameter; a second capillary portion having a second diameter smaller than the first diameter; and a turn portion connecting the first capillary portion and the second capillary portion and being extended to be bent. The number of the turn portion per unit area is greatest at a central portion of the base plate.

In one or more embodiments, the capillary may be point-symmetric based on a center point of the base plate.

In one or more embodiments, each of the plurality of patterned portions may further include a third capillary portion having a third diameter greater than the first diameter. The third capillary portion may be arranged between the first capillary portion and the turn portion.

In one or more embodiments, the base plate may include first to fourth areas partitioned by a first reference line passing through a center point of the base plate and being extended in a first direction and a second reference line passing through the center point of the base plate and being extended in a second direction intersecting the first direction. The capillary may be bent at the central portion of the base plate, at an edge of the base plate, and at a central portion of each of the first to fourth areas.

In one or more embodiments, the turn portion may include a first turn portion connecting the first capillary portion and the second capillary portion included in a same patterned portion among the plurality of patterned portions and a second turn portion connecting the first capillary portion and the second capillary portion included in different patterned portions among the plurality of patterned portions.

In one or more embodiments, the turn portion may include a first connecting portion connected to the first capillary portion and a second connecting portion connected to the second capillary portion. The first connecting portion and the second connecting portion may have different diameters.

A heat pipe according to one or more embodiments of the present disclosure includes: a base plate including a first side being extended in a first direction and a second side contacting the first side and being extended in a second direction intersecting the first direction; a capillary on the base plate and including a plurality of patterned portions connected to each other to form a closed loop; and a cover plate arranged on one surface of the base plate and covering the capillary. Each of the plurality of patterned portions includes: a first capillary portion having a first diameter and being extended in a diagonal direction between the first direction and the second direction; a second capillary portion having a second diameter smaller than the first diameter and being extended in the diagonal direction; and a turn portion connecting the first capillary portion and the second capillary portion and being extended to be bent. The number of the turn portion per unit area is greatest at a central portion of the base plate.

In one or more embodiments, each of the plurality of patterned portions may further include a third capillary portion having a third diameter greater than the first diameter and being extended in the diagonal direction. The third capillary portion may be arranged between the first capillary portion and the turn portion.

In one or more embodiments, the capillary may further include an extension portion connected to some (e.g., at least one) of the plurality of patterned portions at an edge of the base plate and being extended in the first direction and in the second direction.

In one or more embodiments, a first end of the extension portion may be connected to the first capillary portion, and a second end opposite to the first end of the extension portion may be connected to the second capillary portion.

In one or more embodiments, the base plate may include first to fourth areas partitioned by a first reference line passing through a center point of the base plate and being extended in the first direction and a second reference line passing through the center point of the base plate and being extended in the second direction.

In one or more embodiments, the capillary may be bent at the central portion of the base plate and at an edge of each of the first to fourth areas.

In one or more embodiments, the capillary may be bent at the central portion of the base plate, at an edge of the base plate, at the first reference line, and at the second reference line.

In one or more embodiments, the turn portion may include a first turn portion connecting the first capillary portion and the second capillary portion located in a same area among the first to fourth areas and a second turn portion connecting the first capillary portion and the second capillary portion located in different areas among the first to fourth areas.

In one or more embodiments, the first turn portion may be extended to be bent at an edge of the base plate, and the second turn portion may be extended to be bent at the first reference line or the second reference line. A curvature of the first turn portion may be greater than a curvature of the second turn portion.

In one or more embodiments, the capillary may further include a bridge portion passing through a center point of the base plate, being extended in the first direction or the second direction, and connected to at least one of the plurality of patterned portions.

In one or more embodiments, the bridge portion may be connected to the turn portion.

In one or more embodiments, the bridge portion may include a first bridge portion passing through the center point of the base plate and being extended in the first direction and a second bridge portion passing through the center point of the base plate and being extended in the second direction.

In one or more embodiments, the first bridge portion and the second bridge portion may have different diameters.

An electronic device according to one or more embodiments of the present disclosure includes: a display panel including a pixel; a power supply configured to provide power to the display panel; and a heat pipe configured to dissipate heat generated from the display panel. The heat pipe includes: a base plate, a capillary on the base plate and including a plurality of patterned portions connected to each other to form a closed loop; and a cover plate arranged on one surface of the base plate and covering the capillary. Each of the plurality of patterned portions includes: a first capillary portion having a first diameter; a second capillary portion having a second diameter smaller than the first diameter; and a turn portion connecting the first capillary portion and the second capillary portion and being extended to be bent. The number of the turn portion per unit area is greatest at a central portion of the base plate.

A heat pipe according to one or more embodiments of the present disclosure may include a base plate and a capillary on the base plate and including a plurality of patterned portions connected to each other to form a closed loop. Each of the plurality of patterned portions may include a first capillary portion having a first diameter, a second capillary portion having a second diameter smaller than the first diameter, and a turn portion that connects the first capillary portion and the second capillary portion and being extended to be bent.

The number of the turn portion per unit area may be greatest at a central portion of the base plate. Accordingly, the heat pipe may quickly dissipate heat emitted from an external heat source in an area overlapping the central portion of the base plate in a plan view.

### BRIEF DESCRIPTION OF THE DRAWINGS

Illustrative, non-limiting embodiments will be more clearly understood from the following detailed description in conjunction with the accompanying drawings.
FIG. 1 is a plan view illustrating a display device.
FIG. 2 is a cross-sectional view illustrating the display device of FIG. 1.
FIG. 3 is a cross-sectional view illustrating a heat pipe.
FIG. 4 is a plan view illustrating the heat pipe of FIG. 3.
FIG. 5 is an enlarged plan view of area A of FIG. 4.
FIG. 6 is an enlarged plan view illustrating an example of a portion of an area of FIG. 5.
FIG. 7 is an enlarged plan view illustrating another example of a portion of an area of FIG. 5.
FIG. 8 is a plan view illustrating a flow of a working fluid inside the heat pipe of FIG. 4.
FIG. 9 is a plan view illustrating a heat.
FIG. 10 is an enlarged plan view of area B of FIG. 9.
FIG. 11 is a plan view illustrating a flow of a working fluid inside the heat pipe of FIG. 9.
FIG. 12 is a plan view illustrating a heat pipe.
FIG. 13 is an enlarged plan view of area C of FIG. 12.
FIG. 14 is a plan view illustrating a flow of a working fluid inside the heat pipe of FIG. 12.
FIG. 15 is a plan view illustrating a heat pipe.
FIG. 16 is an enlarged plan view of area D of FIG. 15.
FIG. 17 is a plan view illustrating a flow of a working fluid inside the heat pipe of FIG. 15.
FIG. 18 is a block diagram illustrating an electronic device.
FIG. 19 is a view illustrating an example of the electronic device of FIG. 18 as including a computer monitor.

### DETAILED DESCRIPTION

Hereinafter, embodiments of the present disclosure will be described in more detail with reference to the accompanying drawings. The same reference numerals are used for the same components in the drawings, and redundant descriptions of the same components will not be provided.

In the present specification, "including A or B", "A and/or B", etc., represents A or B, or A and B.

As used herein, the term "and/or" includes any and all combinations of one or more of the associated listed items. As used herein, expressions such as "at least one of", "one of", and "selected from", when preceding a list of elements, modify the entire list of elements and do not modify the individual elements of the list. For example, "at least one of a, b or c", "at least one selected from a, b and c", etc., may indicate only a, only b, only c, both (e.g., simultaneously) a and b, both (e.g., simultaneously) a and c, both (e.g., simultaneously) b and c, all of a, b, and c, or variations thereof.

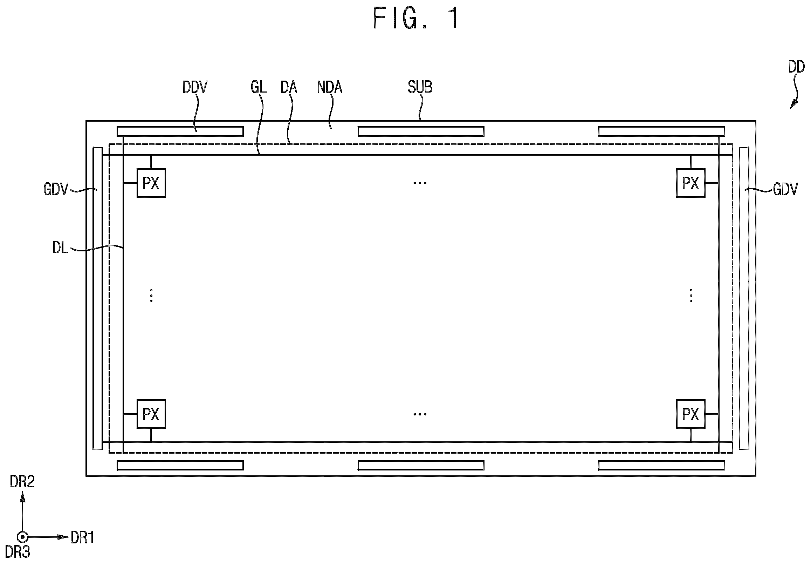

FIG. 1 is a plan view illustrating a display device.

In this specification, a plane may be defined by a first direction DR1 and a second direction DR2 intersecting the first direction DR1. For example, the first direction DR1 and the second direction DR2 may be normal (e.g., perpendicular) to each other. A direction normal to the plane, that is, a thickness direction of a display device DD may be a third direction DR3. For example, the third direction DR3 may be normal (e.g., perpendicular) to each of the first direction DR1 and the second direction DR2. As used herein the "plan view" is a view in the third direction DR3.

Referring to FIG. 1, the display device DD may be a device activated in response to an electrical signal. As illustrated in FIG. 1, the display device DD may be a relatively medium-to large-sized display device used in relatively medium-to large-sized electronic devices such as laptops, tablet PCs, televisions, computer monitors, automotive monitors, exterior billboards, and/or the like. However, the present disclosure is not limited thereto, and the display device DD may be a small-sized display device used in small-sized electronic devices such as smartphones, cell phones, smart watches, cameras, and/or the like.

The display device DD may have a substantially rectangular planar shape having a long side being extended (extending) in the first direction DR1 and a short side being extended (extending) in the second direction DR2. However, the present disclosure is not limited thereto, and the display device DD may have any one of square, circular, or elliptical planar shapes. The planar shape of the display device DD may be one or more suitable shapes.

The display device DD may include a display area DA and a non-display area NDA. The display area DA may be an area that is configured to display an image by generating light or adjusting the transmittance of light proved from an external light source. The non-display area NDA may be positioned on a periphery of the display area DA. For example, the non-display area NDA may be around (e.g., surround) at least a portion of the display area DA. The non-display area NDA may be an area that is not configured to display an image.

The display device DD may include a substrate SUB, pixels PX, a gate line GL, a data line DL, a data driver DDV, and a gate driver GDV.

The substrate SUB may form a base of the display device DD. The substrate SUB may include a transparent material or an opaque material. The substrate SUB may be formed of a transparent resin substrate. A polyimide substrate may be an example of the transparent resin substrate. In this case, the polyimide substrate may include a first organic layer, a first barrier layer, a second organic layer, and/or the like. The substrate SUB may include a quartz substrate, a synthetic quartz substrate, a calcium fluoride substrate, a fluorine-doped quartz substrate, a soda-lime glass substrate, a non-alkali glass substrate, and/or the like. These may be used alone or in combination with each other.

The pixels PX may be arranged in the display area DA on the substrate SUB. The pixels PX may be electrically connected to the gate line GL and the data line DL. For example, the pixels PX may be arranged in a matrix along the first direction DR1 and the second direction DR2. Each of the pixels PX may include a pixel driving circuit and a light-emitting element. The light-emitting element may be configured to emit light. The light-emitting element may be an organic light-emitting diode or an inorganic light-emitting diode.

The gate line GL and the data line DL may intersect each other. For example, the gate line GL may be extended in the first direction DR1 and may be arranged along the second direction DR2. The data line DL may be extended in the second direction DR2 and may be arranged along the first direction DR1.

The data driver DDV may be arranged in the non-display area NDA on the substrate SUB. The data driver DDV may generate a data voltage. The data driver DDV may output the data voltage to the data line DL. The data voltage may be applied to the pixels PX through the data line DL.

The display device DD may include a plurality of data drivers DDV. For example, the data drivers DDV may be arranged on both sides (e.g., opposite sides) of the display area DA in the second direction DR2. For example, the data drivers DDV may be arranged along the long side of the display device DD. However, the present disclosure is not limited thereto. For example, the display area DA may be between data drivers DDV.

The gate driver GDV may be arranged in the non-display area NDA on the substrate SUB. The gate driver GDV may generate a gate signal. The gate driver GDV may output the gate signal to the gate line GL. The gate signal may be applied to the pixels PX through the gate line GL. The gate driver GDV may be arranged on both sides (e.g., opposite sides) of the display area DA in the first direction DR1. However, the present disclosure is not limited thereto. For example, the display area DA may be between the gate drivers GDV.

The number or arrangement of the data drivers DDV and the number or arrangement of the gate drivers GDV illustrated in FIG. 1 are merely examples, and the present disclosure is not limited thereto.

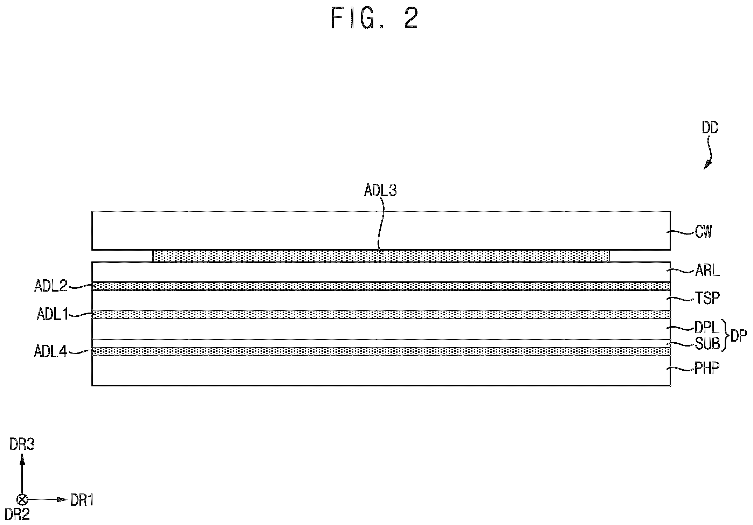

FIG. 2 is a cross-sectional view illustrating the display device of FIG. 1.

Referring to FIG. 2, the display device DD may include a display panel DP, a touch member TSP, an anti-reflection layer ARL, a cover window CW, and a heat pipe PHP.

The display panel DP may include the pixels PX. The display panel DP may include the substrate SUB and a display element layer DPL arranged on the substrate SUB. The display element layer DPL may include a plurality of light-emitting elements that are each configured to emit light. Each of the light-emitting elements may include a lower electrode, a light-emitting layer, and an upper electrode. A hole provided in the lower electrode and an electron provided in the upper electrode may combine to form an exciton in the light-emitting layer, and the light-emitting layer may be configured to emit light as the exciton changes from an excited state to a ground state. The light-emitting layer may be configured to emit light having a specific color (e.g., red, green, and blue). For example, the light-emitting layer may include at least one of an organic light-emitting material or a quantum dot.

The touch member TSP may be arranged on the display panel DP. The touch member TSP may be attached to an upper surface of the display panel DP through a first adhesive member ADL1. The touch member TSP may be arranged directly on the display panel DP. For example, the touch member TSP may be arranged directly on the display panel DP without an adhesive member.

The touch member TSP may detect a user's touch. For example, the touch member TSP may acquire coordinate information based on an external input such as a user's touch. The touch member TSP may detect the external input using a mutual capacitance method and/or a self-capacitance method.

The first adhesive member ADL1 may be arranged between the display panel DP and the touch member TSP. The first adhesive member ADL1 may attach the display panel DP and the touch member TSP.

The anti-reflection layer ARL may be arranged on the touch member TSP. The anti-reflection layer ARL may be attached to an upper surface of the touch member TSP through a second adhesive member ADL2. The anti-reflection layer ARL may reduce the external light reflection of the display device DD. As the external light reflection is reduced, the visibility of the display device DD may be improved. The anti-reflection layer ARL may include a polarizer and/or a phase retarder. In an alternative embodiment, the anti-reflection layer ARL may include color filters and a black matrix arranged between the color filters.

The second adhesive member ADL2 may be arranged between the touch member TSP and the anti-reflection layer ARL. The second adhesive member ADL2 may attach the touch member TSP and the anti-reflection layer ARL.

The cover window CW may be arranged on the anti-reflection layer ARL. The cover window CW may be attached to an upper surface of the anti-reflection layer ARL through a third adhesive member ADL3. The cover window CW may cover and protect the display panel DP. The cover window CW may include a transparent material to allow light provided by the display panel DP to pass through to the outside of the display device DD. For example, the cover window CW may include glass, quartz, polymer, and/or the like.

The third adhesive member ADL3 may be arranged between the anti-reflection layer ARL and the cover window CW. The third adhesive member ADL3 may attach the anti-reflection layer ARL and the cover window CW to each other.

The heat pipe PHP may be arranged under the display panel DP. For example, the heat pipe PHP may be attached to a lower surface of the substrate SUB through a fourth adhesive member ADL4. For example, the fourth adhesive member ADL 4 may be between the heat pipe PHP and the substrate SUB. The heat pipe PHP may effectively or suitably dissipate heat generated by the display panel DP and the data driver (DDV, refer to FIG. 1).

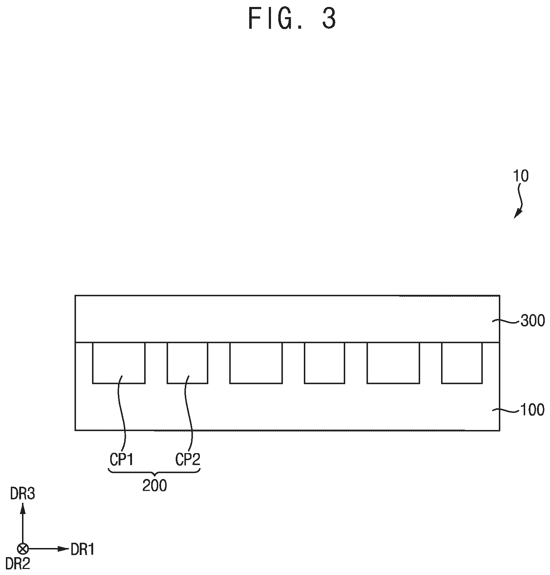

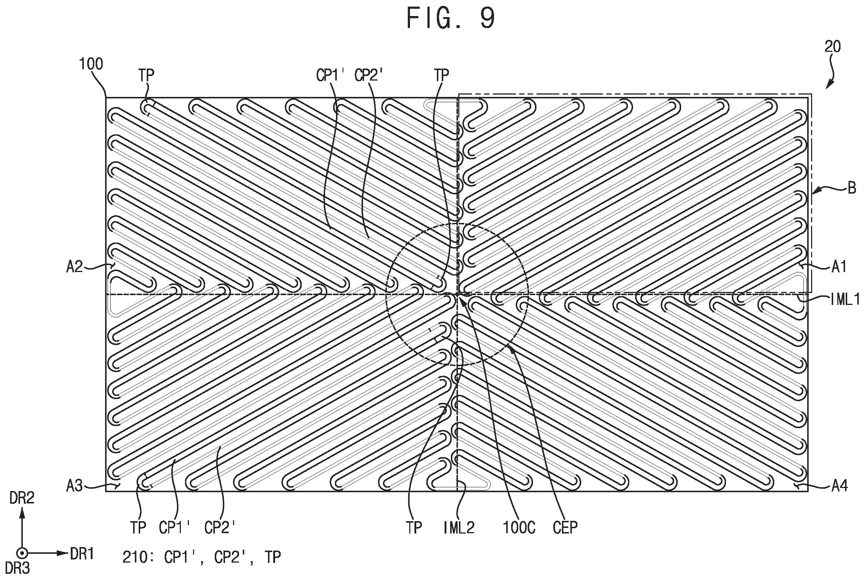

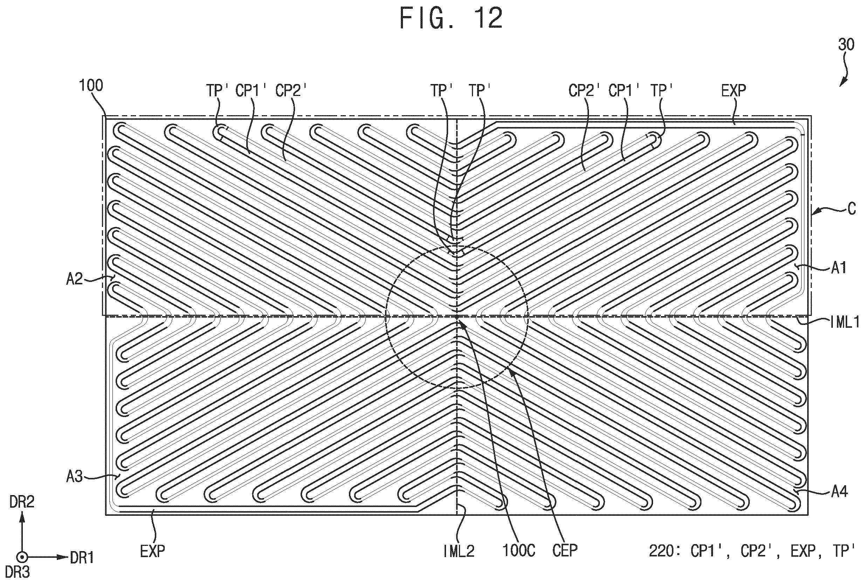

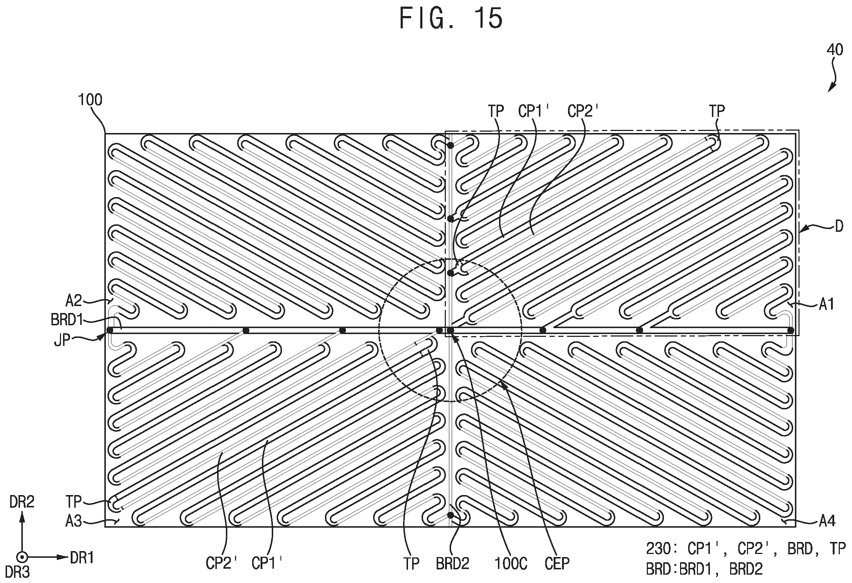

The heat pipe PHP included in the display device DD may correspond to any one of the heat pipe 10 illustrated in FIGS. 3 to 8, the heat pipe 20 illustrated in FIGS. 9 to 11, the heat pipe 30 illustrated in FIGS. 12 to 14, or the heat pipe 40 illustrated in FIGS. 15 to 17.

The fourth adhesive member ADL4 may be arranged between the display panel DP and the heat pipe PHP. The fourth adhesive member ADL4 may attach the display panel DP and the heat pipe PHP.

Each of the first adhesive member ADL1, the second adhesive member ADL2, the third adhesive member ADL3, and the fourth adhesive member ADL4 may include a pressure sensitive adhesive ("PSA") film, an optically clear adhesive ("OCA") film, or an optically clear resin ("OCR").

FIG. 3 is a cross-sectional view illustrating a heat pipe.

Referring to FIG. 3, a heat pipe 10 may include a base plate 100, a capillary 200, and a cover plate 300.

The base plate 100 may define a substantial outer shape of the heat pipe 10. The base plate 100 may be flat plate shaped (e.g., in a form of plates). However, the present disclosure is not limited thereto, and the shape of the base plate 100 may be one or more suitable shapes.

The base plate 100 may include a metal or a polymeric resin. Examples of the metal that may be used as the base plate 100 may include aluminum (Al), copper (Cu), stainless steel, and/or the like. These may be used alone or in combination with each other. Examples of the polymeric resin that may be used as the base plate 100 may include polyethylene ("PE"), polycarbonate ("PC"), polypropylene ("PP"), polytetrafluoroethylene ("PTFE"), and/or the like. Accordingly, the base plate 100 may be flexible and may be easily bent (e.g., may be bendable). However, the present disclosure is not limited thereto.

A first through-hole and a second through-hole may be formed on a side surface of the base plate 100. For example, the first through-hole may be formed on a first side surface of the base plate 100, and the second through-hole may be formed on a second side surface, the second side surface being opposite the first side surface of the base plate 100. For example, the first through-hole and the second through-hole may be opposite to each other. A level of the first through-hole and a level of the second through-hole may be equal (e.g., substantially equal) to each other. For example, a height at which the first through-hole is formed may be the same (e.g., substantially the same) as a height at which the second through-hole is formed. However, the present disclosure is not limited thereto.

When injecting a working fluid into the heat pipe 10 or discharging the working fluid from the heat pipe 10, the working fluid or air, and/or the like, may be injected through one of the first through-hole and the second through-hole, and a non-condensed gas may be sucked through the other of the first through-hole and the second through-hole. For example, the first through-hole may be an injection port for injecting the working fluid or air, and/or the like, and the second through-hole may be a vacuum port for sucking the non-condensed gas.

The working fluid may be injected inside the capillary 200. For example, the working fluid may be a refrigerant. Examples of the refrigerant that may be used as the working fluid may include water (H₂O), ammonia (NH₃), methanol (CH₃OH), ethanol (C₂H₅OH), R134a, HFE7000, FC72, R290, hydrofluoroolefin ("HFO")-based refrigerant, and/or the like. However, the present disclosure is not limited thereto.

The capillary 200 may be formed on the base plate 100. For example, the capillary 200 may be formed on an upper surface of the base plate 100. For example, the capillary 200 may be formed by patterning (e.g., etching) the base plate 100 using a photoresist. However, the present disclosure is not limited thereto.

The capillary 200 may provide a flow path through which the working fluid flows. When the working fluid is injected into the capillary 200 after making the capillary 200 in a vacuum state, a slug-train unit including a liquid slug and a vapor plug may be formed inside the capillary 200. Thereafter, if (e.g., when) heat is supplied to the capillary 200, the slug-train unit may self-oscillate at high speed. When the amount of heat supplied to the capillary 200 is relatively small, the slug-train unit may oscillate in both (e.g., opposite) directions with a small amplitude. When the amount of heat supplied to the capillary 200 increases, the slug-train unit may not flow in both (e.g., opposite) directions, but may circulate in one direction. Accordingly, the heat delivered to the heat pipe 10 may be dissipated through the oscillating flow and circulating flow of the slug-train unit. For example, the heat pipe 10 may be a pulsating heat pipe ("PHP").

In other words, the capillary 200 may provide a flow path for the working fluid. When the working fluid is injected into the vacuumed capillary 200, a slug-train unit, composed of a liquid slug and a vapor plug, forms inside. Upon heating, this slug-train unit may self-oscillate at high speeds. With low heat, the unit may oscillate in both directions with small amplitude. As heat increases, it circulates in one direction, aiding in heat dissipation through oscillating and circulating flows.

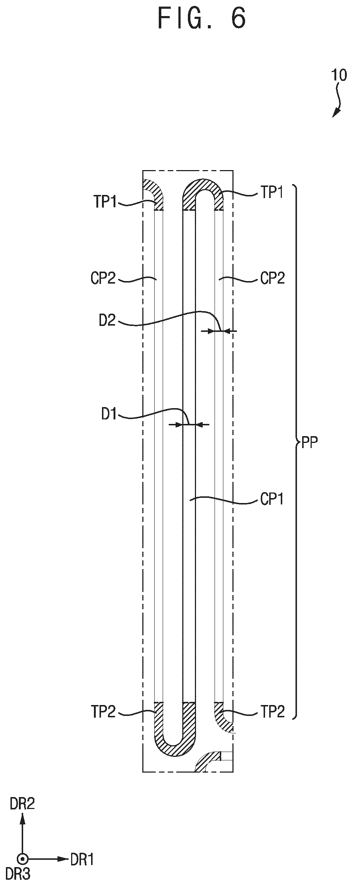

In example embodiments, the capillary 200 may include a first capillary portion CP1 and a second capillary portion CP2 having different diameters. For example, the first capillary portion CP1 may have a first diameter (D1, refer to FIG. 6) and the second capillary portion CP2 may have a second diameter (D2, refer to FIG. 6) that is smaller than the first diameter. As the second capillary portion CP2 has the relatively small second diameter, the capillary force of the liquid slug may be increased. A detailed description thereof will be described in more detail with reference to FIG. 6.

In other words, the capillary 200 may include two portions with different diameters: a first capillary portion CP1 with a larger diameter (D1) and a second capillary portion CP2 with a smaller diameter (D2). The smaller diameter of CP2 increases the capillary force on the liquid slug, enhancing the performance of the heat pipe.

The cover plate 300 may be arranged on one surface of the base plate 100. For example, the cover plate 300 may be attached to the upper surface of the base plate 100. For example, the cover plate 300 may be joined to the base plate 100. As the cover plate 300 is attached to the upper surface of the base plate 100, the cover plate 300 may cover the capillary 200. For example, the cover plate 300 may seal the capillary 200.

The cover plate 300 may include a metal or a polymeric resin. Examples of the metal that may be used as the cover plate 300 may include aluminum (Al), copper (Cu), stainless steel, and/or the like. These may be used alone or in combination with each other. Examples of the polymeric resin that may be used as the cover plate 300 may include polyethylene ("PE"), polycarbonate ("PC"), polypropylene ("PP"), polytetrafluoroethylene ("PTFE"), and/or the like. Accordingly, the cover plate 300 may be flexible and may be easily bent (e.g., may be bendable). However, the present disclosure is not limited thereto.

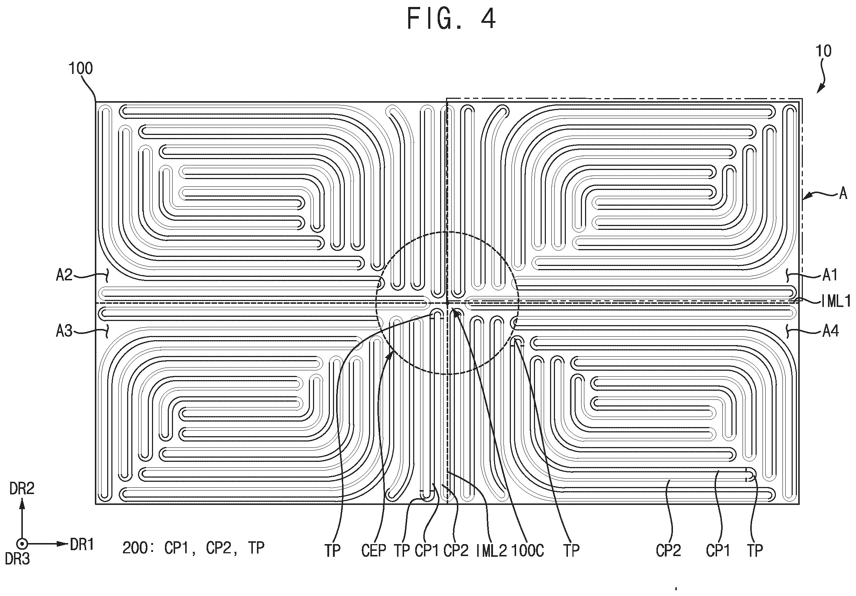

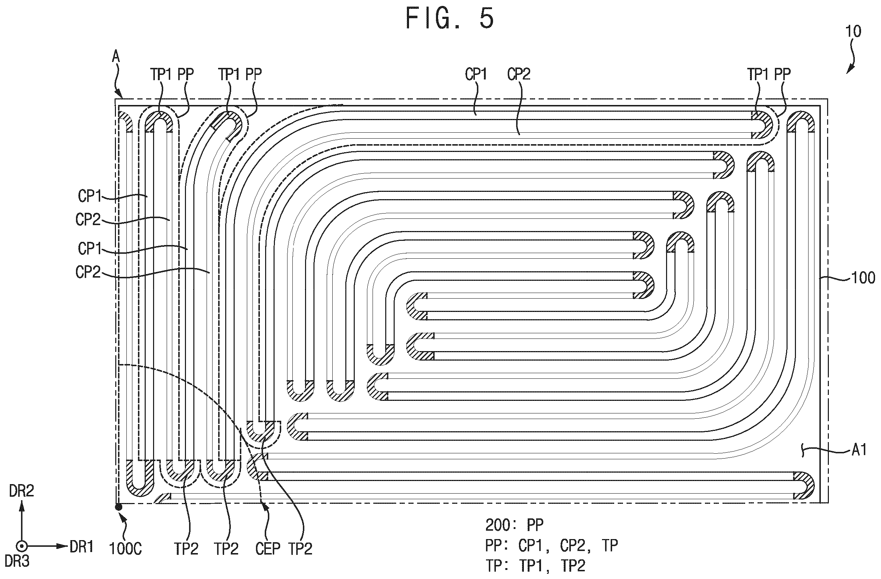

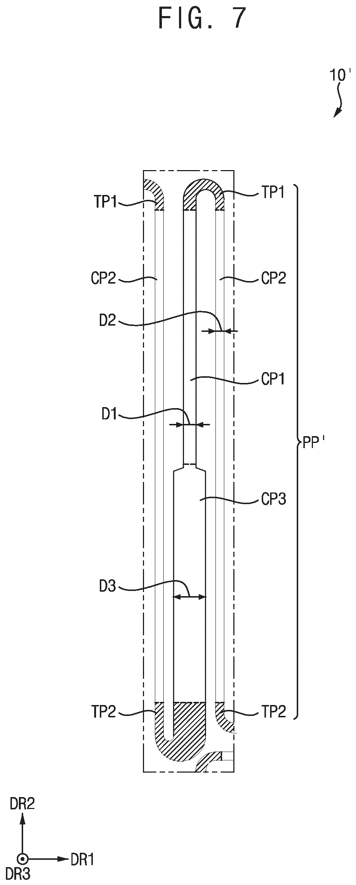

FIG. 4 is a plan view illustrating the heat pipe of FIG. 3. FIG. 5 is an enlarged plan view of area A of FIG. 4. FIG. 6 is an enlarged plan view illustrating an example of a portion of an area of FIG. 5. FIG. 7 is an enlarged plan view illustrating another example of a portion of an area of FIG. 5.

Referring to FIG. 4, the heat pipe 10 may include the base plate 100 and the capillary 200 formed on the base plate 100.

The base plate 100 may have a substantially rectangular planar shape having a long side extending in the first direction DR1 and a short side extending in the second direction DR2. An area (or a size) of the base plate 100 may be greater than or equal to an area (or a size) of the display panel (DP, refer to FIG. 2). For example, a length in the first direction DR1 of the base plate 100 may be about 600 millimeters, and a length in the second direction DR2 of the base plate 100 may be about 330 millimeters. However, the present disclosure is not limited thereto, and the area (or, the size) of the base plate 100 may be one or more suitable areas in consideration of the area (or, the size) of the display panel.

As illustrated in FIG. 4, four areas may be defined, bounded by a straight line extending in the first direction DR1 and a straight line extending in the second direction DR2 based on a center point 100C of the base plate 100. For example, the base plate 100 may include first to fourth areas A1, A2, A3, A4 partitioned by a first reference straight line IML1 passing through the center point 100C of the base plate 100 and being extended in the first direction DR1 and a second reference straight line IML2 passing through the center point 100C of the base plate 100 and being extended in the second direction DR2. The first area A1 may be located above the first reference line IML1 and to the right of the second reference line IML2. The second area A2 may be located above the first reference line IML1 and to the left of the second reference line IML2. The third area A3 may be located below the first reference line IML1 and to the left of the second reference line IML2. The fourth area A4 may be located below the first reference line IML1 and to the right of the second reference line IML2.

The capillary 200 may be formed on the upper surface of the base plate 100. The capillary 200 may be formed over an area (e.g., an entire area) of the base plate 100. For example, the capillary 200 may be formed in (e.g., entirely in) the first to fourth areas A1, A2, A3, A4. For example, the capillary 200 may be formed in (e.g., entirely in) the first to fourth areas A1, A2, A3, A4 to dissipate heat generated at a random location of the display panel (DP, refer to FIG. 2). For example, the capillary 200 may overlap (e.g., entirely overlap) the display panel in a plan view. Accordingly, the heat pipe 10 may effectively or suitably dissipate heat generated at a random location of the display panel.

The capillary 200 may be formed with multiple bends. For example, the capillary 200 may have a structure in which a single capillary is bent in multiple steps to form a closed loop. The capillary 200 may include a plurality of patterned portions (PP, refer to FIG. 5) that are connected to each other to form a closed loop. Each of the patterned portions may include the first capillary portion CP1 having the first diameter, the second capillary portion CP2 having the second diameter smaller than the first diameter, and a turn portion TP (also referred to as a pipe bend) that connects the first capillary portion CP1 and the second capillary portion CP2 and is extended to be bent (forms a bend, for example a 180° bend so that the capillary bends back on itself). In the present disclosure, unless otherwise defined, "diameter" refers to the diameter or average diameter for circular portions (e.g., capillary portions). For non-circular portions, "diameter" refers to the major axis length or average major axis length.

The capillary 200 may be bent at one or more suitable locations of the base plate 100. For example, as illustrated in FIG. 4, the capillary 200 may be bent at one or more suitable locations such as a central portion CEP of the base plate 100, an edge of the base plate 100, a central portion of each of the first to fourth areas A1, A2, A3, A4, and/or the like. For example, the turn portion TP may form a bend at one or more suitable locations such as the central portion CEP of the base plate 100, the edge of the base plate 100, the central portion of each of the first to fourth areas A1, A2, A3, A4, and/or the like.

The number of turn portions TP per unit area may be greatest at the central portion CEP of the base plate 100. Accordingly, the heat pipe 10 may more quickly dissipate heat emitted from the display panel in an area overlapping the central portion CEP of the base plate 100 in a plan view. For example, the turn portions TP at the central portion CEP of the base plate 100 may be arranged radially (e.g., substantially radially) based on the center point 100C of the base plate 100, but the present disclosure is not limited thereto.

The capillary 200 may be point-symmetric based on the center point 100C of the base plate 100. For example, the shape of the capillary 200 overlapping the first area A1 may be point-symmetric with the shape of the capillary 200 overlapping the third area A3 based on the center point 100C of the base plate 100. For example, the shape of the capillary 200 overlapping the third area A3 may be the same (e.g., substantially the same) as the shape of the capillary 200 overlapping the first area A1 rotated by 180 degrees. In addition, the shape of the capillary 200 overlapping the second area A2 may be point-symmetric with the shape of the capillary 200 overlapping the fourth area A4 based on the center point 100C of the base plate 100. For example, the shape of the capillary 200 overlapping the fourth area A4 may be the same (e.g., substantially the same) as the shape of the capillary 200 overlapping the second area A2 rotated by 180 degrees. However, the present disclosure is not limited thereto. Hereinafter, the description will focus on the first area A1 of the base plate 100.

Referring further to FIGS. 5 and 6, the capillary 200 may include patterned portions PP that are connected to each other to form a closed loop. Each of the patterned portions PP may include the first capillary portion CP1, the second capillary portion CP2, and the turn portion TP. The turn portion TP may include a first turn portion TP1 and a second turn portion TP2.

The first capillary portion CP1 may have a first diameter D1. For example, the first capillary portions CP1 respectively included in the patterned portions PP may have the same first diameter D1. For example, the first diameter D1 may be about 2.6 millimeters, but the present disclosure is not limited thereto. The first diameter D1 of the first capillary portion CP1 may be one or more suitable diameters depending on the type (kind) of the working fluid.

Some of the first capillary portions CP1 may be extended only in a straight line, and other of the first capillary portions CP1 may include a straight portion being extended in a straight line and a curved portion having a set or predetermined curvature. The first capillary portions CP1 may have different lengths. The first capillary portion CP1 may be connected to the second capillary portion CP2 through the turn portion TP.

The second capillary portion CP2 may have a second diameter D2 that is smaller than the first diameter D1. For example, the second capillary portions CP2 respectively included in the patterned portion PP may have the same second diameter D2. For example, the second diameter D2 may be about 1.0 millimeter, but the present disclosure is not limited thereto. The second diameter D2 of the second capillary portion CP2 may be one or more suitable diameters depending on the type (kind) of the working fluid.

Some of the second capillary portions CP2 may extend only in a straight line, and other of the second capillary portions CP2 may include a straight portion extending in a straight line and a curved portion having a set or predetermined curvature. The second capillary portions CP2 may have different lengths. The second capillary portion CP2 may be connected to the first capillary portion CP1 through the turn portion TP.

The turn portion TP may connect the first capillary portion CP1 and the second capillary portion CP2, and may be bent, for example through 180°, so that the first and second capillary portions are substantially parallel but fluid flows through them in opposite directions. The turn portion TP may include a first connecting portion that contacts the first capillary portion CP1 and a second connecting portion that contacts the second capillary portion CP2. The first connecting portion and the second connecting portion may have different diameters. For example, a diameter of the first connecting portion may be equal (e.g., substantially equal) to the first diameter D1 of the first capillary portion CP1, and a diameter of the second connecting portion may be equal (e.g., substantially equal) to the second diameter D2 of the second capillary portion CP2.

The turn portion TP may include the first turn portion TP1 and the second turn portion TP2. The first turn portion TP1 may connect the first capillary portion CP1 and the second capillary portion CP2 included in the same (e.g., substantially the same) patterned portion PP. For example, the first turn portion TP1 may connect the first capillary portion CP1 included in one patterned portion PP and the second capillary portion CP2 included in the one patterned portion PP. The second turn portion TP2 may connect the first capillary portion CP1 and the second capillary portion CP2 included in different patterned portions PP. For example, the second turn portion TP2 may connect the second capillary portion CP2 included in one patterned portion PP and the first capillary portion CP1 included in the other patterned portion PP.

The capillary 200 may be bent at one or more suitable locations of the base plate 100. For example, the turn portion TP may be extended to be bent at one or more suitable locations of the base plate 100. For example, as illustrated in FIG. 5, the turn portion TP may be bent at one or more suitable locations such as the central portion CEP of the base plate 100, an edge of the first area A1, a central portion of the first area A1, and/or the like. Accordingly, the total length of the capillary 200 formed on the base plate 100 may be relatively increased. For example, because the surface area between the base plate 100 and the capillary 200 may be relatively increased, the heat dissipation performance of the heat pipe 10 may be improved.

When the area of the heat pipe 10 (or, the base plate 100) becomes relatively large in correspondence to the area of the display panel (DP, refer to FIG. 2), a problem may occur in which the working fluid filled inside the capillary 200 fails to move from a lower portion of the base plate 100 to an upper portion of the base plate 100. For example, a problem may occur in which a liquid slug filled inside the capillary 200 fails to move from the lower portion of the base plate 100 to the upper portion of the base plate 100 by gravity. For example, a problem may occur in which the liquid slug filled inside the capillary 200 remains at the lower portion of the base plate 100 by gravity. In this case, a problem may occur in which a slug-train unit including the liquid slug and a vapor plug does not circulate, resulting in a deterioration of the heat dissipation performance of the heat pipe 10.

To prevent or reduce the liquid slug from remaining at the lower portion of the base plate 100, the first diameter D1 of the first capillary portion CP1 may be greater than the second diameter D2 of the second capillary portion CP2. As the first capillary portion CP1 has a relatively large first diameter D1, a vapor pressure of the vapor plug may be increased. Accordingly, in the slug-train unit, the vapor plug may apply a greater pressure to the liquid slug. As the second capillary portion CP2 has the relatively small second diameter D2, the capillary force of the liquid slug may be increased.

In addition, to prevent or reduce the liquid slug from remaining at the lower portion of the base plate 100, the capillary 200 may be bent at one or more suitable locations of the base plate 100. For example, as illustrated in FIG. 4, the capillary 200 may be bent at one or more suitable locations, such as the central portion CEP of the base plate 100, the edge of the base plate 100, the central portion of each of the first to fourth areas A1, A2, A3, A4, and/or the like. In this case, compared to if (e.g., when) the capillary 200 is bent only at both opposite ends in the second direction DR2 of the base plate 100, the slug-train unit (or the working fluid) may be more uniformly (e.g., substantially uniformly) distributed inside the capillary 200 formed over the area (e.g., entire area) of the base plate 100. In addition, compared to if (e.g., when) the capillary 200 is bent only at both opposite ends in the first direction DR1 of the base plate 100, the slug-train unit may be more uniformly (e.g., substantially uniformly) distributed inside the capillary 200 formed over the area (e.g., entire area) of the base plate 100. As the vapor pressure of the vapor plug is increased, the capillary force of the liquid slug is increased, and the slug-train unit is more uniformly (e.g., substantially uniformly) distributed inside the capillary 200, the slug-train unit (or the working fluid) may circulate even if (e.g., when) the area of the base plate 100 is relatively large. For example, the problem of the liquid slug remaining at the lower portion of the base plate 100 may be effectively suppressed or reduced.

In summary, when the area of the heat pipe 10 (or base plate 100) is relatively large compared to the display panel, the working fluid inside the capillary 200 may fail to move from the lower to the upper portion of the base plate due to gravity. This can cause the liquid slug to remain at the lower portion, preventing the slug-train unit (comprising the liquid slug and vapor plug) from circulating, which deteriorates the heat dissipation performance of the heat pipe 10. To address this, the first capillary portion CP1 is designed with a larger diameter (D1) than the second capillary portion CP2, increasing the vapor pressure and capillary force on the liquid slug. Additionally, bending the capillary 200 at various locations on the base plate 100 helps distribute the slug-train unit more uniformly, ensuring effective circulation and heat dissipation even with a larger base plate area.

Referring further to FIG. 7, a patterned portion PP' may further include a third capillary portion CP3 having a third diameter D3 greater than the first diameter D1. For example, the third diameter D3 may be about 4.0 millimeters, but the present disclosure is not limited thereto. The third diameter D3 of the third capillary portion CP3 may be one or more suitable diameters depending on the type (kind) of the working fluid.

The third capillary portion CP3 may be arranged between the first capillary portion CP1 and the turn portion TP. For example, the third capillary portion CP3 may be arranged between the first capillary portion CP1 and the second turn portion TP2. For example, the third capillary portion CP3 may be connected to the first capillary portion CP1 and the second turn portion TP2. However, the present disclosure is not limited thereto, and the third capillary portion CP3 may be arranged between the first capillary portion CP1 and the first turn portion TP1. For example, the third capillary portion CP3 may be connected to the first capillary portion CP1 and the first turn portion TP1.

As the diameter of the capillary 200 increases, the vapor pressure of a gas may increase. Therefore, as the third capillary portion CP3 has the relatively large third diameter D3, the vapor pressure of the vapor plug may be further increased. Accordingly, compared to if (e.g., when) the capillary 200 does not include the third capillary portion CP3, the vapor plug may apply a relatively large pressure to the liquid slug. As a result, the slug-train unit (or the working fluid) may circulate more easily even if (e.g., when) the area of the base plate 100 is relatively large. In other words, increasing the diameter of the capillary 200, particularly in the third capillary portion CP3 with a larger diameter (D3), enhances the vapor pressure of the vapor plug. This increased pressure allows the vapor plug to exert greater force on the liquid slug, facilitating easier circulation of the slug-train unit (or working fluid) even when the base plate 100 is relatively large.

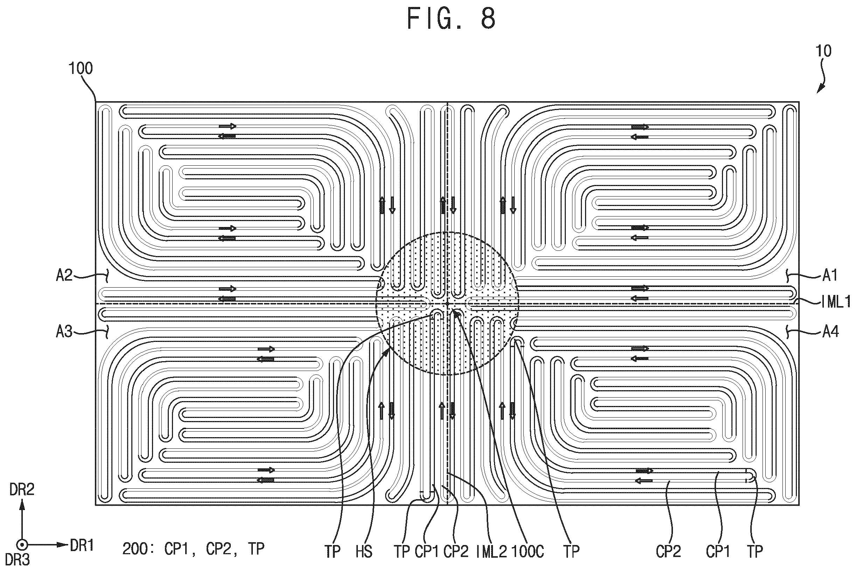

FIG. 8 is a plan view illustrating a flow of a working fluid inside the heat pipe of FIG. 4.

Referring to FIG. 8, an external heat source HS may be located to overlap the central portion (CEP, refer to FIG. 4) of the base plate 100 in a plan view. For example, the external heat source HS may correspond to heat generated from the display panel (DP, refer to FIG. 2). The external heat source HS may transfer heat toward the heat pipe 10.

The heat emitted from the external heat source HS may be transferred to the working fluid filled in the capillary 200. For example, the working fluid may include a slug-train unit including a liquid slug and a vapor plug, and the heat emitted from the external heat source HS may evaporate the liquid slug. Accordingly, a ratio of the vapor plug in the slug-train unit may increase. For example, as the pressure of the vapor plug increases, the slug-train unit may oscillate in both (e.g., opposite) directions. In addition, as the pressure of the vapor plug increases, the vapor plug may apply pressure to the liquid slug, and the slug-train unit may circulate in one direction.

As the slug-train unit oscillates and circulates, the vapor plug may transfer heat to the outside. As the vapor plug transfers heat to the outside, the vapor plug may condense. Through this process, heat transferred to the working fluid may be dissipated. For example, when heat from an external source HS is transferred to the working fluid in the capillary 200, it evaporates the liquid slug in the slug-train unit, increasing the ratio and pressure of the vapor plug. This causes the slug-train unit to oscillate in both directions and circulate in one direction, facilitating heat transfer. As the vapor plug transfers heat to the outside and condenses, the heat carried by the working fluid is dissipated.

As described above, the first diameter (D1, refer to FIG. 6) of the first capillary portion CP1 may be greater than the second diameter (D2, refer to FIG. 6) of the second capillary portion CP2. As the first capillary portion CP1 has the relatively large first diameter, the vapor pressure of the vapor plug may be increased. As the second capillary portion CP2 has the relatively small second diameter, the capillary force of the liquid slug may be increased. Accordingly, the slug-train unit may circulate even if (e.g., when) the area of the base plate 100 is relatively large.

The number of turn portions TP per unit area may be greatest at the central portion (CEP, refer to FIG. 4) of the base plate 100. The turn portion TP may be defined as a portion that connects the first capillary portion CP1 and the second capillary portion CP2 and is extended to be bent. As the number of turn portions TP located in an area overlapping the external heat source HS in a plan view increases, the slug-train unit may circulate more easily, and heat transferred to the working fluid may be more quickly dissipated. For example, the heat pipe 10 may more quickly dissipate the heat emitted by the external heat source HS in an area overlapping the central portion of the base plate 100 in a plan view. In other words, when heat from an external source (HS) is transferred to the working fluid in the capillary 200, it evaporates the liquid slug, increasing the vapor plug's ratio and pressure. This causes the slug-train unit to oscillate and circulate, facilitating heat transfer. As the vapor plug transfers heat and condenses, the heat carried by the working fluid is dissipated. Also, in the present context and unless otherwise defined, a plan view is a drawing or diagram viewed from above, showing the layout or arrangement of components on a horizontal plane. It provides a top-down perspective, often used in engineering and architectural designs to illustrate the spatial relationships and dimensions of various elements.

In FIG. 8, an example is illustrated if (e.g., when) the external heat source HS overlaps the central portion of the base plate 100 in a plan view, but the present disclosure is not limited thereto. The external heat source HS may overlap any area of the base plate 100 in a plan view. To dissipate heat emitted by the heat source HS overlapping any area of the base plate 100 in a plan view, the capillary 200 may be formed (e.g., entirely formed) in the first to fourth areas A1, A2, A3, A4, and the capillary 200 may be bent at one or more suitable locations of the base plate 100.

If a portion of the capillary 200 where the working fluid evaporates is defined as an evaporation portion, and a portion of the capillary 200 where the working fluid condenses is defined as a condensation portion, the evaporation portion and the condensation portion may not be defined at fixed locations in the heat pipe 10. For example, the external heat source HS may overlap any area of the base plate 100 in a plan view, and the evaporation portion may be defined as a portion of the capillary 200 that overlaps the external heat source HS in a plan view. The condensation portion may be defined as a portion of the capillary 200 where the working fluid condenses as the working fluid oscillates and circulates near the evaporation portion.

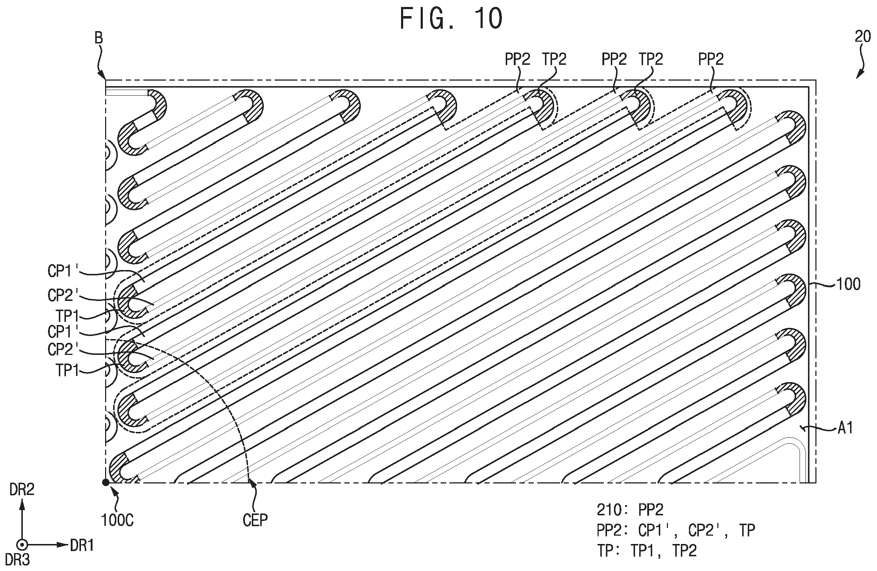

FIG. 9 is a plan view illustrating a heat pipe. FIG. 10 is an enlarged plan view of area B of FIG. 9.

Referring to FIG. 9, a heat pipe 20 may include the base plate 100, a capillary 210, and the cover plate (300, refer to FIG. 3).

The heat pipe 20 of FIG. 9 may be the same (e.g., substantially the same) as the heat pipe 10 described above with reference to FIGS. 3 to 7, except for the planar shape of the capillary 210. Hereinafter, redundant descriptions of the heat pipe 10 described above with reference to FIGS. 3 to 7 may not be provided or may be summarized.

The base plate 100 may include a first side extending in the first direction DR1 and a second side contacting the first side and extending in the second direction DR2. A length of the first side may be greater than a length of the second side. For example, the base plate 100 may have a substantially rectangular planar shape with a long side being extended in the first direction DR1 and a short side being extended in the second direction DR2.

As illustrated in FIG. 9, the base plate 100 may include the first to fourth areas A1, A2, A3, A4 partitioned by the first reference line IML1 passing through the center point 100C of the base plate 100 and being extended in the first direction DR1 and the second reference line IML2 passing through the center point 100C of the base plate 100 and being extended in the second direction DR2.

The capillary 210 may be formed on the upper surface of the base plate 100. The capillary 210 may be formed over the area (e.g., entire area) of the base plate 100. For example, the capillary 210 may be formed (e.g., entirely formed) in the first to fourth areas A1, A2, A3, A4. For example, the capillary 210 may be formed (e.g., entirely formed) in the first to fourth areas A1, A2, A3, A4 to dissipate heat generated at a random location of the display panel (DP, refer to FIG. 2). For example, the capillary 210 may overlap (e.g., entirely overlap) the display panel in a plan view. Accordingly, the heat pipe 20 may effectively or suitably dissipate heat generated at a random location of the display panel.

The capillary 210 may be formed with multiple bends. For example, the capillary 210 may have a structure in which a single capillary is bent in multiple steps to form a closed loop. The capillary 210 may include a plurality of patterned portions (PP2, refer to FIG. 10) that are connected to each other to form a closed loop. Each of the patterned portions may include a first capillary portion CP1' having a first diameter and being extended in a diagonal direction between the first direction DR1 and the second direction DR2, a second capillary portion CP2' having a second diameter smaller than the first diameter and being extended in the diagonal direction, and a turn portion TP that connects the first capillary portion CP1' and the second capillary portion CP2' and is bent, for example through 180°.

The capillary 210 may be bent at one or more suitable locations of the base plate 100. For example, as illustrated in FIG. 9, the capillary 210 may be bent at one or more suitable locations, such as the central portion CEP of the base plate 100, an edge of each of the first to fourth areas A1, A2, A3, A4, and/or the like. For example, the turn portion TP may extend to be bent at one or more suitable locations, such as the central portion CEP of the base plate 100, the edge of each of the first to fourth areas A1, A2, A3, A4, and/or the like.

The number of turn portions TP per unit area may be greatest at the central portion CEP of the base plate 100. Accordingly, the heat pipe 20 may more quickly dissipate heat emitted by the display panel in an area overlapping the central portion CEP of the base plate 100 in a plan view.

The capillary 210 may be point-symmetric based on the center point 100C of the base plate 100. For example, the shape of the capillary 210 overlapping the first area A1 may be point-symmetric with the shape of the capillary 210 overlapping the third area A3 based on the center point 100C of the base plate 100. In addition, the shape of the capillary 210 overlapping the second area A2 may be point-symmetric with the shape of the capillary 210 overlapping the fourth area A4 based on the center point 100C of the base plate 100. However, the present disclosure is not limited thereto. Hereinafter, the description will focus on the first area A1 of the base plate 100.

Referring further to FIG. 10, the capillary 210 may include patterned portions PP2 that are connected to each other to form a closed loop. Each of the patterned portions PP2 may include the first capillary portion CP1', the second capillary portion CP2', and the turn portion TP. The turn portion TP may include a first turn portion TP1 and a second turn portion TP2.

The first capillary portion CP1' may have the first diameter (D1, refer to FIG. 6). For example, the first capillary portions CP1' respectively included in the patterned portions PP2 may have the same first diameter. As the first capillary portions CP1' have the relatively large first diameter, the vapor pressure of the vapor plug may be increased.

Each of the first capillary portions CP1' may be extended in a diagonal direction between the first direction DR1 and the second direction DR2. For example, each of the first capillary portions CP1' may be extended diagonally. The first capillary portions CP1' may have different lengths. The first capillary portion CP1' may be connected to the second capillary portion CP2' through the turn portion TP.

The second capillary portion CP2' may have the second diameter (D2, refer to FIG. 6) smaller than the first diameter. For example, the second capillary portions CP2' respectively included in the patterned portions PP2 may have the same second diameter. As the second capillary portion CP2' has the relatively small second diameter, the capillary force of the liquid slug may be increased.

Each of the second capillary portions CP2' may extend in the diagonal direction between the first direction DR1 and the second direction DR2. For example, each of the second capillary portions CP2' may extend diagonally. The second capillary portions CP2' may have different lengths. The second capillary portion CP2' may be connected to the first capillary portion CP1' through the turn portion TP.

The turn portion TP may connect the first capillary portion CP1' and the second capillary portion CP2' and may be bent, for example through 180°. The turn portion TP may include a first connecting portion that contacts the first capillary portion CP1' and a second connecting portion that contacts the second capillary portion CP2'. The first connecting portion and the second connecting portion may have different diameters. For example, a diameter of the first connecting portion may be equal (e.g., substantially equal) to the first diameter of the first capillary portion CP1', and a diameter of the second connecting portion may be equal (e.g., substantially equal) to the second diameter of the second capillary portion CP2'.

The turn portion TP may include the first turn portion TP1 and the second turn portion TP2. The first turn portion TP1 may connect the first capillary portion CP1' and the second capillary portion CP2' included in substantially the same patterned portion PP2. For example, the first turn portion TP1 may connect the first capillary portion CP1' included in one patterned portion PP2 and the second capillary portion CP2' included in the one patterned portion PP2. The second turn portion TP2 may connect the first capillary portion CP1' and the second capillary portion CP2' included in different patterned portions PP2. For example, the second turn portion TP2 may connect the second capillary portion CP2' included in one patterned portion PP2 and the first capillary portion CP1' included in the other patterned portion PP2.

The capillary 210 may be bent at one or more suitable locations of the base plate 100. For example, the turn portion TP may be extended to be bent at one or more suitable locations of the base plate 100. For example, as illustrated in FIGS. 9 and 10, the turn portion TP may be bent at one or more suitable locations, such as the central portion CEP of the base plate 100, the edge of each of the first to fourth areas A1, A2, A3, A4, and/or the like. Accordingly, the total length of the capillary 210 formed on the base plate 100 may be relatively increased. For example, because the surface area between the base plate 100 and the capillary 210 may be relatively increased, the heat dissipation performance of the heat pipe 20 may be improved.

In addition, if (e.g., when) the capillary 210 is bent at one or more suitable locations of the base plate 100, compared to the case where the capillary 210 is bent only at both (e.g., opposite) ends in the second direction DR2 and/or both (e.g., opposite) ends in the first direction DR1 of the base plate 100, the slug-train unit (or the working fluid) may be more uniformly (e.g., substantially uniformly) distributed inside the capillary 210 formed over the area (e.g., entire area) of the base plate 100. As the vapor pressure of the vapor plug is increased, the capillary force of the liquid slug is increased, and the slug-train unit is more uniformly (e.g., substantially uniformly) distributed inside the capillary 210, the slug-train unit (or the working fluid) may circulate even if (e.g., when) the area of the base plate 100 is relatively large. For example, the problem of the liquid slug remaining at the lower portion of the base plate 100 may be effectively suppressed or reduced.

The patterned portion PP2 may further include a third capillary portion having the third diameter (D3, refer to FIG. 7) greater than the first diameter and extending in a diagonal direction between the first direction DR1 and the second direction DR2. In this case, the third capillary portion may be arranged between the first capillary portion CP1' and the turn portion TP. For example, the third capillary portion may be connected to the first capillary portion CP1' and the turn portion TP.

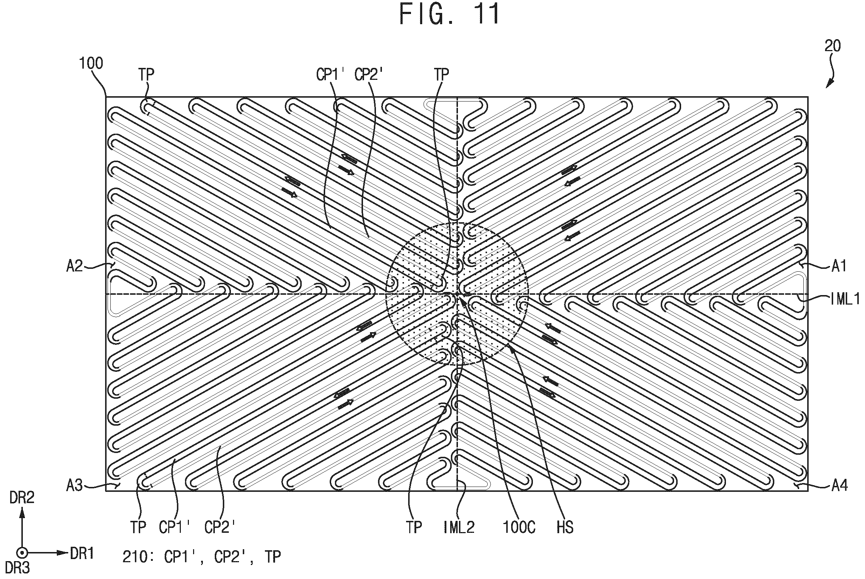

FIG. 11 is a plan view illustrating a flow of a working fluid inside the heat pipe of FIG. 9.

Referring to FIG. 11, an external heat source HS may be located to overlap the central portion (CEP, refer to FIG. 9) of the base plate 100 in a plan view. For example, the external heat source HS may correspond to heat generated from the display panel (DP, refer to FIG. 2). The external heat source HS may transfer heat toward the heat pipe 20.

The number of turn portions TP per unit area may be greatest at the central portion of the base plate 100. As the number of turn portions TP located in an area overlapping the external heat source HS in a plan view increases, the slug-train unit filled in the capillary 210 may circulate more easily, and the heat transferred to the working fluid may be more quickly dissipated. For example, the heat pipe 20 may more quickly dissipate the heat emitted from the external heat source HS in an area overlapping the central portion of the base plate 100 in a plan view.

Unlike the capillary 200 described with reference to FIG. 8, the capillary 210 of FIG. 11 may include the first capillary portion CP1' and the second capillary portion CP2' being extended in a diagonal direction between the first direction DR1 and the second direction DR2. As each of the first capillary portion CP1' and the second capillary portion CP2' is extended in the diagonal direction, the liquid slug may be affected by a relatively weak gravitational force. For example, because the liquid slug is subject to gravity in an opposite direction of the second direction DR2 and moves in the diagonal direction inside the capillary 210, the liquid slug may be affected by a relatively weak gravitational force during the movement of the liquid slug.

Accordingly, the slug-train unit may circulate more easily even if (e.g., when) the area of the base plate 100 is relatively large. As a result, the problem of the liquid slug remaining at the lower portion of the base plate 100 due to gravity may be effectively suppressed or reduced.

To summarize, in a plan view, an external heat source HS may overlap the central portion of the base plate 100, transferring heat to the heat pipe 20. The central portion has the highest number of turn portions TP per unit area, facilitating easier circulation of the slug-train unit and quicker heat dissipation. The capillary 210, unlike the capillary 200, includes first and second capillary portions CP1' and CP2' extending diagonally, reducing the gravitational force on the liquid slug. This design helps the slug-train unit circulate more effectively, even with a large base plate area, thereby mitigating the issue of the liquid slug remaining at the lower portion due to gravity.

In FIG. 11, an example is illustrated if (e.g., when) the external heat source HS overlaps the central portion of the base plate 100 in a plan view, but the present disclosure is not limited thereto. The external heat source HS may overlap any area of the base plate 100 in a plan view.

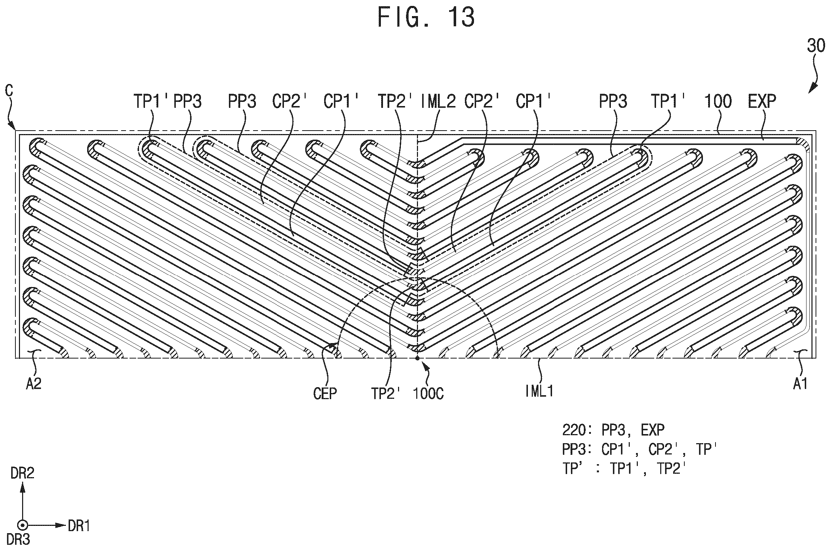

FIG. 12 is a plan view illustrating a heat pipe. FIG. 13 is an enlarged plan view of area C of FIG. 12.

Referring to FIG. 12, a heat pipe 30 may include the base plate 100, a capillary 220, and the cover plate (300, refer to FIG. 3).

The heat pipe 30 of FIG. 12 may be the same (e.g., substantially the same) as the heat pipe 10 described above with reference to FIGS. 3 to 7, except for the planar shape of the capillary 220. Hereinafter, redundant descriptions of the heat pipe 10 described above with reference to FIGS. 3 to 7 may not be provided or may be summarized.

The base plate 100 may include the first side being extended in the first direction DR1 and the second side contacting the first side and being extended in the second direction DR2. A length of the first side may be greater than a length of the second side. For example, the base plate 100 may have a substantially rectangular planar shape with a long side being extended in the first direction DR1 and a short side being extended in the second direction DR2.

As illustrated in FIG. 12, the base plate 100 may include the first to fourth areas A1, A2, A3, A4 partitioned by the first reference line IML1 passing through the center point 100C of the base plate 100 and being extended in the first direction DR1 and the second reference line IML2 passing through the center point 100C of the base plate 100 and being extended in the second direction DR2.

The capillary 220 may be formed on the upper surface of the base plate 100. The capillary 220 may be formed over the area (e.g., entire area) of the base plate 100. For example, the capillary 220 may be formed (e.g., entirely formed) in the first to fourth areas A1, A2, A3, A4. For example, the capillary 220 may be formed (e.g., entirely formed) in the first to fourth areas A1, A2, A3, A4 to dissipate heat generated at a random location of the display panel (DP, refer to FIG. 2). For example, the capillary 220 may overlap (e.g., entirely overlap) the display panel in a plan view. Accordingly, the heat pipe 30 may effectively or suitably dissipate heat generated at a random location of the display panel.

The capillary 220 may be formed with multiple bends. For example, the capillary 220 may have a structure in which a single capillary is bent in multiple stages to form a closed loop. The capillary 220 may include a plurality of patterned portions (PP3, refer to FIG. 13) that are connected to each other to form a closed loop and an extension portion EXP that is connected to some of the patterned portions.

Each of the patterned portions may include the first capillary portion CP1' having a first diameter and being extended in a diagonal direction between the first direction DR1 and the second direction DR2, the second capillary portion CP2' having a second diameter smaller than the first diameter and being extended in the diagonal direction, and a turn portion TP' connecting the first capillary portion CP1' and the second capillary portion CP2' and bent so that the two capillary portions are inclined at an angle relative to one another.

The extension portion EXP may include a first portion extending in the first direction DR1 and a second portion connected to the first portion and extending in the second direction DR2. The extension portion EXP may extend in the first direction DR1 and the second direction DR2 at an edge of the base plate 100. The extension portion EXP may be connected to some of the patterned portions at the edge of the base plate 100. For example, as illustrated in FIG. 12, the extension portion EXP may be connected to some of the patterned portions at the edge of the base plate 100 overlapping the first are A1 and the third area A3. However, the present disclosure is not limited thereto.

The capillary 220 may be bent at one or more suitable locations of the base plate 100. For example, as illustrated in FIG. 12, the capillary 220 may be bent at one or more suitable locations, such as the central portion CEP of the base plate 100, the edge of the base plate 100, the first reference line IML1, the second reference line IML2, and/or the like. For example, the turn portion TP' may be bent at one or more suitable locations such as the central portion CEP of the base plate 100, the edge of the base plate 100, the first reference line IML1, the second reference line IML2, and/or the like.

The number of turn portions TP' per unit area may be greatest at the central portion CEP of the base plate 100. Accordingly, the heat pipe 30 may more quickly dissipate heat emitted by the display panel in an area overlapping the central portion CEP of the base plate 100 in a plan view.

The capillary 220 may be point-symmetric based on the center point 100C of the base plate 100. For example, the shape of the capillary 220 overlapping the first area A1 may be point-symmetric with the shape of the capillary 220 overlapping the third area A3 based on the center point 100C of the base plate 100. In addition, the shape of the capillary 220 overlapping the second area A2 may be point-symmetric with the shape of the capillary 220 overlapping the fourth area A4 based on the center point 100C of the base plate 100. However, the present disclosure is not limited thereto. Hereinafter, the description will focus on the first area A1 of the base plate 100.

Referring further to FIG. 13, the capillary 220 may include patterned portions PP3 that are connected to each other to form a closed loop and the extension portion EXP that is connected to some of the patterned portions PP3. Each of the patterned portions PP3 may include the first capillary portion CP1', the second capillary portion CP2', and the turn portion TP'. The turn portion TP' may include a first turn portion TP1' and a second turn portion TP2'.

The first capillary portion CP1' may have the first diameter (D1, refer to FIG. 6). For example, the first capillary portions CP1' respectively included in the patterned portions PP3 may have the same first diameter. As the first capillary portion CP1' has the relatively large first diameter, the vapor pressure of the vapor plug may be increased.

Each of the first capillary portions CP1' may extend in a diagonal direction between the first direction DR1 and the second direction DR2. The first capillary portions CP1' may have different lengths. The first capillary portion CP1' may be connected to the second capillary portion CP2' through the turn portion TP'.

The second capillary portion CP2' may have the second diameter (D2, refer to FIG. 6) smaller than the first diameter. For example, the second capillary portions CP2' respectively included in the patterned portion PP3 may have the same second diameter. As the second capillary portion CP2' has the relatively small second diameter, the capillary force of the liquid slug may be increased.

Each of the second capillary portions CP2' may be extended in a diagonal direction between the first direction DR1 and the second direction DR2. The second capillary portions CP2' may have different lengths. The second capillary portion CP2' may be connected to the first capillary portion CP1' through the turn portion TP'.

The turn portion TP' may connect the first capillary portion CP1' and the second capillary portion CP2' and may be extended to be bent. The turn portion TP' may include a first connecting portion that contacts the first capillary portion CP1' and a second connecting portion that contacts the second capillary portion CP2'. The first connecting portion and the second connecting portion may have different diameters. For example, a diameter of the first connecting portion may be equal (e.g., substantially equal) to the first diameter of the first capillary portion CP1', and a diameter of the second connecting portion may be equal (e.g., substantially equal) to the second diameter of the second capillary portion CP2'.

The turn portion TP' may include the first turn portion TP1' and the second turn portion TP2'. The first turn portion TP1' may connect the first capillary portion CP1' and the second capillary portion CP2' located in the same area (e.g., substantially the same area) among the first to fourth areas A1, A2, A3, A4. The second turn portion TP2' may connect the first capillary portion CP1' and the second capillary portion CP2' located in different areas among the first to fourth areas A1, A2, A3, A4. For example, as illustrated in FIG. 13, the first turn portion TP1' may connect the first capillary portion CP1' located in the first area A1 and the second capillary portion CP2' located in the first area A1. The first turn portion TP1' may connect the first capillary portion CP1' located in the second area A2 and the second capillary portion CP2' located in the second area A2. The second turn portion TP2' may connect the first capillary portion CP1' located in the first area A1 and the second capillary portion CP2' located in the second area A2. The second turn portion TP2' may connect the second capillary portion CP2' located in the first area A1 and the first capillary portion CP1' located in the second area A2.

The first turn portion TP1' may be extended to be bent at the edge of the base plate 100, and the second turn portion TP2' may be extended to be bent at the first reference line IML1 or the second reference line IML2.

The first turn portion TP1' and the second turn portion TP2' may have different curvatures. For example, as illustrated in FIG. 13, the curvature of the first turn portion TP1' may be greater than the curvature of the second turn portion TP2'. For example, a radius of curvature of the first turn portion TP1' may be smaller than a radius of curvature of the second turn portion TP2'.

The extension portion EXP may include a first portion extending in the first direction DR1 and a second portion connected to the first portion and extending in the second direction DR2. The extension portion EXP may extend in the first direction DR1 and the second direction DR2 at the edge of the base plate 100. For example, the extension portion EXP may be connected to some of the patterned portions PP3 at the edge of the base plate 100 overlapping the first area A1.

A first end of the extension portion EXP may be connected to the first capillary portion CP1', and a second end opposite to the first end of the extension portion EXP may be connected to the second capillary portion CP2'. For example, the first portion of the extension portion EXP being extended in the first direction DR1 may be connected to the first capillary portion CP1' of one patterned portion PP3. In this case, a diameter of the first portion of the extension portion EXP may be equal (e.g., substantially equal) to the first diameter of the first capillary portion CP1'. The second portion of the extension portion EXP being extended in the second direction DR2 may be connected to the second capillary portion CP2' of the other patterned portion PP3. In this case, a diameter of the second portion of the extension portion EXP may be equal (e.g., substantially equal) to the second diameter of the second capillary portion CP2'. However, the present disclosure is not limited thereto. The first portion of the extension portion EXP may be connected to the second capillary portion CP2' and have the second diameter, and the second portion of the extension portion EXP may be connected to the first capillary portion CP1' and have the first diameter.

The capillary 220 may be bent at one or more suitable locations of the base plate 100. For example, the turn portion TP' may be extended to be bent at one or more suitable locations of the base plate 100. For example, as illustrated in FIGS. 12 and 13, the turn portion TP' may be bent at one or more suitable locations, such as the central portion CEP of the base plate 100, the edge of the base plate 100, the first reference line IML1, the second reference line IML2, and/or the like. Accordingly, the total length of the capillary 220 formed on the base plate 100 may be relatively increased. For example, because the surface area between the base plate 100 and the capillary 220 may be relatively increased, the heat dissipation performance of the heat pipe 30 may be improved.

In addition, if (e.g., when) the capillary 220 is bent at one or more suitable locations of the base plate 100, compared to the case where the capillary 220 is bent only at both opposite ends in the second direction DR2 and/or both opposite ends in the first direction DR1 of the base plate 100, the slug-train unit (or the working fluid) may be more uniformly (e.g., substantially uniformly) distributed inside the capillary 220 formed over the area (e.g., entire area) of the base plate 100. As the vapor pressure of the vapor plug is increased, the capillary force of the liquid slug is increased, and the slug-train unit is more uniformly (e.g., substantially uniformly) distributed inside the capillary 220, the slug-train unit (or the working fluid) may circulate even if (e.g., when) the area of the base plate 100 is relatively large. For example, the problem of the liquid slug remaining at the lower portion of the base plate 100 may be effectively suppressed or reduced.

The patterned portion PP3 may further include a third capillary portion having the third diameter (D3, refer to FIG. 7) greater than the first diameter and being extended in a diagonal direction between the first direction DR1 and the second direction DR2. In this case, the third capillary portion may be arranged between the first capillary portion CP1' and the turn portion TP'. For example, the third capillary portion may be connected to the first capillary portion CP1' and the turn portion TP'.

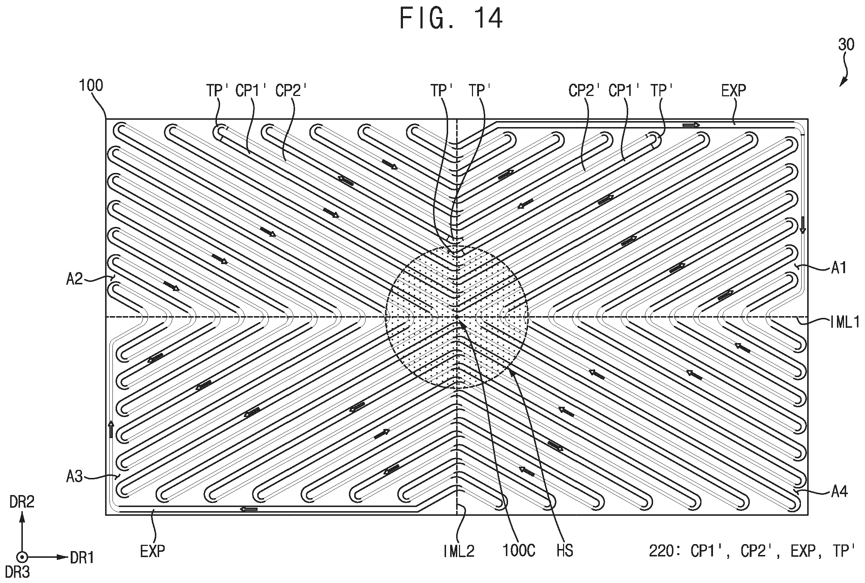

FIG. 14 is a plan view illustrating a flow of a working fluid inside the heat pipe of FIG. 12.

Referring to FIG. 14, an external heat source HS may be located to overlap the central portion (CEP, refer to FIG. 12) of the base plate 100 in a plan view. For example, the external heat source HS may correspond to heat generated from the display panel (DP, refer to FIG. 2). The external heat source HS may transfer heat toward the heat pipe 30.

The number of turn portions TP' per unit area may be greatest at the central portion of the base plate 100. As the number of turn portions TP' located in an area overlapping the external heat source HS in a plan view increases, the slug-train unit filled in the capillary 220 may circulate more easily, and the heat transferred to the working fluid may be more quickly dissipated. For example, the heat pipe 30 may more quickly dissipate the heat emitted from the external heat source HS in an area overlapping the central portion of the base plate 100 in a plan view.

Unlike the capillary 200 described above with reference to FIG. 8, the capillary 220 of FIG. 14 may include the first capillary portion CP1' and the second capillary portion CP2' extending in a diagonal direction between the first direction DR1 and the second direction DR2. As each of the first capillary portion CP1' and the second capillary portion CP2' extends in the diagonal direction, the liquid slug may be affected by a relatively weak gravitational force. Accordingly, the slug-train unit may circulate more easily even if (e.g., when) the area of the base plate 100 is relatively large. As a result, the problem of the liquid slug remaining at the lower portion of the base plate 100 due to gravity may be effectively suppressed or reduced.

Unlike the capillary 210 described above with reference to FIG. 11, the capillary 220 of FIG. 14 may include the second turn portion (TP2', refer to FIG. 13) that connects the first capillary portion CP1' and the second capillary portion CP2' located in different areas among the first to fourth areas A1, A2, A3, A4.

In the capillary 210 described above with reference to FIG. 11, if (e.g., when) the external heat source HS is located to overlap an area of one of the first to fourth areas A1, A2, A3, A4, the slug-train unit may transfer heat to the outside while circulating mainly in the one area where the external heat source HS is located. For example, if (e.g., when) the external heat source HS is located to overlap the first area A1, the slug-train unit may transfer heat to the outside while circulating mainly in the first area A1.

In comparison, in the capillary 220 of FIG. 14, if (e.g., when) the external heat source HS is located to overlap an area of one of the first to fourth areas A1, A2, A3, A4, the slug-train unit may transfer heat to the outside while circulating in the area where the external heat source HS is located and an area adjacent to the area where the heat source HS is located. For example, if (e.g., when) the external heat source HS is located to overlap the first area A1, the slug-train unit may transfer heat to the outside while circulating mainly in the first area A1 and the second area A2. The slug-train unit may transfer heat to the outside while circulating mainly in the first area A1 and the third area A3. For example, the slug-train unit may circulate more easily, and the heat pipe 30 may more quickly dissipate the heat emitted by the external heat source HS.

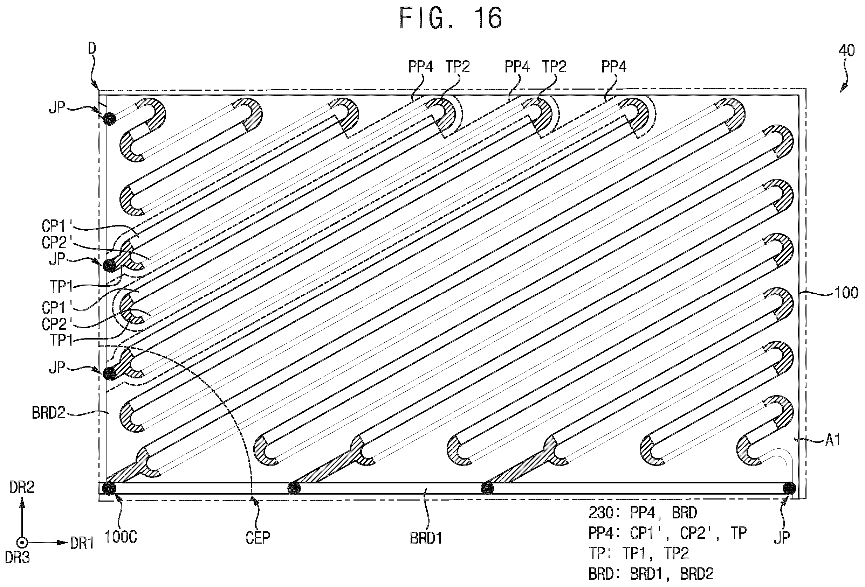

FIG. 15 is a plan view illustrating a heat pipe. FIG. 16 is an enlarged plan view of area D of FIG. 15.

Referring to FIG. 15, a heat pipe 40 may include the base plate 100, a capillary 230, and the cover plate (300, refer to FIG. 3).

The heat pipe 40 of FIG. 15 may be the same (e.g., substantially the same) as the heat pipe 20 described above with reference to FIGS. 9 to 11, except for the planar shape of the capillary 230. For example, the heat pipe 40 of FIG. 15 may be the same (e.g., substantially the same) as the heat pipe 20 described above with reference to FIGS. 9 to 11, except that the capillary 230 may include a bridge portion BRD passing through the center point 100C of the base plate 100 being extended in the first direction DR1 or the second direction DR2. Hereinafter, redundant descriptions of the heat pipe 20 described above with reference to FIGS. 9 to 11 may not be provided or may be summarized.

The base plate 100 may include the first to fourth areas A1, A2, A3, A4 partitioned by the first reference line (IML1, refer to FIG. 9) passing through the center point 100C of the base plate 100 and being extended in the first direction DR1 and the second reference line (IML2, refer to FIG. 9) passing through the center point 100C of the base plate 100 and being extended in the second direction DR2.

The capillary 230 may be formed on the upper surface of the base plate 100. The capillary 230 may be formed over the area (e.g., entire area) of the base plate 100. For example, the capillary 230 may be formed (e.g., entirely formed) in the first to fourth areas A1, A2, A3, A4. For example, the capillary 230 may be formed (e.g., entirely formed) in the first to fourth areas A1, A2, A3, A4 to dissipate heat generated at a random location of the display panel (DP, refer to FIG. 2). For example, the capillary 230 may overlap (e.g., entirely overlap) the display panel in a plan view. Accordingly, the heat pipe 40 may effectively or suitably dissipate heat generated at a random location of the display panel.

The capillary 230 may be formed with multiple bends. For example, the capillary 230 may have a structure in which a single capillary is bent in multiple steps to form a closed loop. The capillary 230 may include a plurality of patterned portions (PP4, refer to FIG. 16) that are connected to each other to form a closed loop and a bridge portion BRD that is connected to some of the patterned portions.

Each of the patterned portions may include the first capillary portion CP1' having a first diameter and being extended in a diagonal direction between the first direction DR1 and the second direction DR2, the second capillary portion CP2' having a second diameter smaller than the first diameter and being extended in the diagonal direction, and the turn portion TP connecting the first capillary portion CP1' and the second capillary portion CP2' and being extended to be bent.

The bridge portion BRD may pass through the center point 100C of the base plate 100 and may extend in the first direction DR1 or the second direction DR2. The bridge portion BRD may include a first bridge portion BRD1 and a second bridge portion BRD2. The first bridge portion BRD1 may pass through the center point 100C of the base plate 100 and be extended in the first direction DR1. The second bridge portion BRD2 may pass through the center point 100C of the base plate 100 and may extend in the second direction DR2. The first to fourth areas A1, A2, A3, A4 may be partitioned by the first bridge portion BRD1 and the second bridge portion BRD2.

The first bridge portion BRD1 and the second bridge portion BRD2 may be connected to some of the patterned portions. For example, the first bridge portion BRD1 and the second bridge portion BRD2 may form a contact point JP with some of the patterned portions. In FIG. 15, the first bridge portion BRD1 and the second bridge portion BRD2 are illustrated as being connected to the turn portion TP formed in the first area A1 and the third area A3, but the present disclosure is not limited thereto. The first bridge portion BRD1 and the second bridge portion BRD2 may be connected to the turn portion TP formed in the second area A2 or the fourth area A4.

The capillary 230 may be bent at one or more suitable locations of the base plate 100. For example, as illustrated in FIG. 15, the capillary 230 may be bent at one or more suitable locations, such as the central portion CEP of the base plate 100, an edge of each of the first to fourth areas A1, A2, A3, A4, and/or the like. For example, the turn portion TP may be extended to be bent at one or more suitable locations, such as the central portion CEP of the base plate 100, the edge of each of the first to fourth areas A1, A2, A3, A4, and/or the like.

The number of turn portions TP per unit area may be greatest at the central portion CEP of the base plate 100. Accordingly, the heat pipe 40 may more quickly dissipate heat emitted by the display panel in an area overlapping the central portion CEP of the base plate 100 in a plan view. Hereinafter, the description will focus on the first area A1 of the base plate 100.

Referring further to FIG. 16, the capillary 230 may include patterned portions PP4 that are connected to each other to form a closed loop and the bridge portion BRD that is connected to some of the patterned portions PP4. Each of the patterned portions PP4 may include the first capillary portion CP1', the second capillary portion CP2', and the turn portion TP. The turn portion TP may include the first turn portion TP1 and the second turn portion TP2. The bridge portion BRD may include the first bridge portion BRD1 and the second bridge portion BRD2.

The first capillary portion CP1' may have the first diameter (D1, refer to FIG. 6). As the first capillary portion CP1' has the relatively large first diameter, the vapor pressure of the vapor plug may be increased. The first capillary portion CP1' may extend in a diagonal direction between the first direction DR1 and the second direction DR2. The first capillary portion CP1' may be connected to the second capillary portion CP2' through the turn portion TP.

The second capillary portion CP2' may have the second diameter (D2, refer to FIG. 6) smaller than the first diameter. As the second capillary portion CP2' has the relatively small second diameter, the capillary force of the liquid slug may be increased. The second capillary portion CP2' may be extended in a diagonal direction between the first direction DR1 and the second direction DR2. The second capillary portion CP2' may be connected to the first capillary portion CP1' through the turn portion TP.

The turn portion TP may connect the first capillary portion CP1' and the second capillary portion CP2' and may be extended to be bent. The turn portion TP may include the first turn portion TP1 and the second turn portion TP2. The first turn portion TP1 may connect the first capillary portion CP1' and the second capillary portion CP2' included in the same (e.g., substantially the same) patterned portion PP4. The second turn portion TP2 may connect the first capillary portion CP1' and the second capillary portion CP2' included in different patterned portions PP4.

The first bridge portion BRD1 may pass through the center point 100C of the base plate 100 and may be extended in the first direction DR1. The second bridge portion BRD2 may pass through the center point 100C of the base plate 100 and may be extended in the second direction DR2. Each of the first bridge portion BRD1 and the second bridge portion BRD2 may be connected to some of the patterned portions PP4. Each of the first bridge portion BRD1 and the second bridge portion BRD2 may be connected to the turn portion TP.

The first bridge portion BRD1 and the second bridge portion BRD2 may have different diameters. For example, a diameter of the first bridge portion BRD1 may be equal (e.g., substantially equal) to the first diameter of the first capillary portion CP1', and a diameter of the second bridge portion BRD2 may be equal (e.g., substantially equal) to the second diameter of the second capillary portion CP2'. However, the present disclosure is not limited thereto, and the diameter of the first bridge portion BRD1 may be equal (e.g., substantially equal) to the second diameter of the second capillary portion CP2', and the diameter of the second bridge portion BRD2 may be equal (e.g., substantially equal) to the first diameter of the first capillary portion CP1'.

The first bridge portion BRD1 and the second bridge portion BRD2 may have the same diameter. For example, the diameter of the first bridge portion BRD1 and the diameter of the second bridge portion BRD2 may be equal (e.g., substantially equal) to the first diameter of the first capillary portion CP1'. However, the present disclosure is not limited thereto, and the diameter of the first bridge portion BRD1 and the diameter of the second bridge portion BRD2 may be equal (e.g., substantially equal) to the second diameter of the second capillary portion CP2'.

The capillary 230 may be bent at one or more suitable locations of the base plate 100. For example, the turn portion TP may be extended to be bent at one or more suitable locations of the base plate 100. For example, as illustrated in FIGS. 15 and 16, the turn portion TP may be bent at one or more suitable locations, such as the central portion CEP of the base plate 100, the edge of each of the first to fourth areas A1, A2, A3, A4, and/or the like. Accordingly, the total length of the capillary 230 formed on the base plate 100 may be relatively increased. For example, because the surface area between the base plate 100 and the capillary 230 may be relatively increased, the heat dissipation performance of the heat pipe 40 may be improved.

In addition, if (e.g., when) the capillary 230 is bent at one or more suitable locations of the base plate 100, compared to the case where the capillary 230 is bent only at both (e.g., opposite) ends in the second direction DR2 and/or both (e.g., simultaneously) ends in the first direction DR1 of the base plate 100, the slug-train unit (or the working fluid) may be more uniformly (e.g., substantially uniformly) distributed inside the capillary 230 formed over the entire area of the base plate 100. As the vapor pressure of the vapor plug is increased, the capillary force of the liquid slug is increased, and the slug-train unit is more uniformly (e.g., substantially uniformly) distributed inside the capillary 230, the slug-train unit (or the working fluid) may circulate even if (e.g., when) the area of the base plate 100 is relatively large. For example, the problem of the liquid slug remaining at the lower portion of the base plate 100 may be effectively or suitably suppressed or reduced.

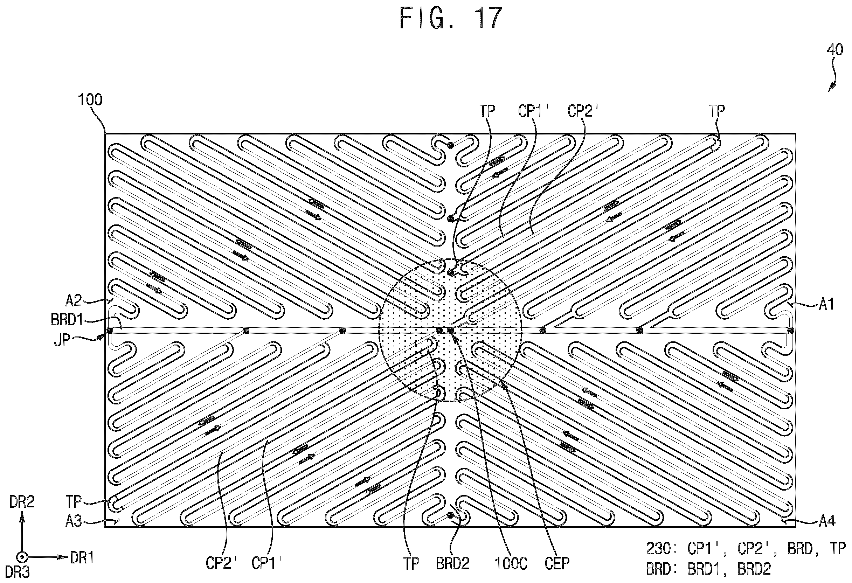

FIG. 17 is a plan view illustrating a flow of a working fluid inside the heat pipe of FIG. 15.

Referring to FIG. 17, an external heat source HS may be located to overlap the central portion (CEP, refer to FIG. 15) of the base plate 100 in a plan view. For example, the external heat source HS may correspond to heat generated from the display panel (DP, refer to FIG. 2). The external heat source HS may transfer heat toward the heat pipe 40.

The number of turn portions TP per unit area may be greatest at the central portion of the base plate 100. As the number of turn portions TP located in an area overlapping the external heat source HS in a plan view increases, the slug-train unit filled in the capillary 230 may circulate more easily, and the heat transferred to the working fluid may be more quickly dissipated. For example, the heat pipe 40 may more quickly dissipate the heat emitted from the external heat source HS in an area overlapping the central portion of the base plate 100 in a plan view.

Unlike the capillary 210 described above with reference to FIG. 11, the capillary 230 of FIG. 17 may further include the bridge portion BRD passing through the center point 100C of the base plate 100 and being extended in the first direction DR1 or the second direction DR2. The bridge portion BRD may be connected to some of the patterned portions (PP4, refer to FIG. 16). For example, the bridge portion BRD may form the contact point JP with the turn portion TP. The bridge portion BRD may further provide a flow path through which the slug-train unit may flow. Accordingly, the bridge portion BRD may induce the slug-train unit to circulate more easily.

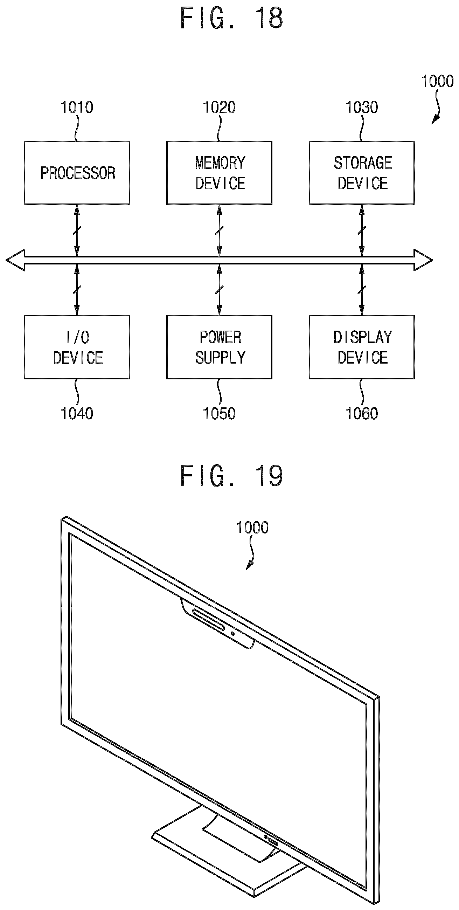

FIG. 18 is a block diagram illustrating an electronic device. FIG. 19 is a view illustrating an example in which the electronic device of FIG. 18 is implemented as a computer monitor.

Referring to FIGS. 18 and 19, an electronic device 1000 may include a processor 1010, a memory device 1020, a storage device 1030, an input/output (I/O) device 1040, a power supply 1050, and a display device 1060. The display device 1060 may be the display device DD of FIGS. 1 and 2. In addition, the electronic device 1000 may further include a plurality of ports for communicating with a video card, a sound card, a memory card, a universal serial bus (USB) device, other systems, and/or the like.

As illustrated in FIG. 19, the electronic device 1000 may be implemented as a computer monitor. However, the electronic device 1000 is not limited thereto. For example, the electronic device 1000 may be implemented as a smart pad, a smart watch, a tablet PC, a car navigation system, a cellular phone, a laptop, a head mounted display ("HMD") device, and/or the like.

The processor 1010 may perform one or more suitable computing functions. The processor 1010 may be a microprocessor, a central processing unit ("CPU"), an application processor ("AP"), and/or the like. The processor 1010 may be coupled to other components through an address bus, a control bus, a data bus, and/or the like. The processor 1010 may be coupled to an extended bus such as a peripheral component interconnection ("PCI") bus.

The memory device 1020 may store data for operations of the electronic device 1000. For example, the memory device 1020 may include at least one non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, and/or the like and/or at least one volatile memory device such as a dynamic random access memory ("DRAM") device, a static random access memory ("SRAM") device, a mobile DRAM device, and/or the like.

The storage device 1030 may include a solid-state drive ("SSD") device, a hard disk drive ("HDD") device, a CD-ROM device, and/or the like. The I/O device 1040 may include an input device such as a keyboard, a keypad, a mouse device, a touch-pad, a touch-screen, and/or the like, and an output device such as a printer, a speaker, and/or the like. The I/O device 1040 may include the display device 1060.

The power supply 1050 may provide power for operations of the electronic device 1000. The display device 1060 may be connected to other components through buses or other communication links.

The present disclosure may be applied to one or more suitable display devices. For example, the present disclosure is applicable to one or more suitable display devices such as display devices for vehicles, ships and aircraft, portable communication devices, display devices for exhibition or information transmission, medical display devices, and/or the like.

The display device, the electronic apparatus, the electronic equipment or device, a manufacturing device for the display device, the electronic apparatus, the electronic equipment or device or any other relevant devices or components according to embodiments described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the present disclosure.

A person of ordinary skill in the art, in view of the present disclosure in its entirety, would appreciate that each suitable feature of the various embodiments may be combined or combined with each other, partially or entirely, and may be technically interlocked and operated in various suitable ways, and each embodiment may be implemented independently of each other or in conjunction with each other in any suitable manner unless otherwise stated or implied.

The foregoing is illustrative of one or more embodiments of the present invention, and is not to be construed as limiting thereof. Although a few embodiments have been described with reference to the drawings, those skilled in the art will readily appreciate that many variations and modifications may be made therein without departing from the scope of the present invention as defined in the appended claims.

## Claims

1. A heat pipe comprising:
a base plate;
a capillary on the base plate and comprising a plurality of patterned portions connected to each other to form a closed loop; and
a cover plate on one surface of the base plate and covering the capillary,
wherein each of the plurality of patterned portions comprises:
a first capillary portion having a first diameter;
a second capillary portion having a second diameter smaller than the first diameter; and
a turn portion connecting the first capillary portion and the second capillary portion, and
wherein the number of turn portions per unit area is greatest at a central portion of the base plate.

2. The heat pipe of claim 1, wherein the capillary is point-symmetric based on a center point of the base plate.

3. The heat pipe of claim 1,
wherein each of the plurality of patterned portions further comprises a third capillary portion having a third diameter greater than the first diameter, and
wherein the third capillary portion is between the first capillary portion and the turn portion.

4. The heat pipe of claim 1,
wherein the base plate comprises first to fourth areas partitioned by a first reference line passing through a center point of the base plate and extending in a first direction and a second reference line passing through the center point of the base plate and extending in a second direction intersecting the first direction, and
wherein the capillary is bent at the central portion of the base plate, at an edge of the base plate, and at a central portion of each of the first to fourth areas.

5. The heat pipe of claim 1, wherein the turn portion comprises:
a first turn portion connecting the first capillary portion and the second capillary portion in the same patterned portion among the plurality of patterned portions; and
a second turn portion connecting the first capillary portion and the second capillary portion in different patterned portions among the plurality of patterned portions.

6. The heat pipe of claim 1,
wherein the turn portion comprises a first connecting portion connected to the first capillary portion and a second connecting portion connected to the second capillary portion, and
wherein the first connecting portion and the second connecting portion have different diameters.

7. The heat pipe of claim 1, wherein the base plate comprises a first side extending in a first direction and a second side contacting the first side and extending in a second direction intersecting the first direction; and
the first capillary portion extends in a diagonal direction between the first direction and the second direction;
the second capillary portion extends in the diagonal direction,
optionally wherein each of the plurality of patterned portions further comprises a third capillary portion having a third diameter greater than the first diameter and extending in the diagonal direction, and
wherein the third capillary portion is between the first capillary portion and the turn portion.

8. The heat pipe of claim 7, wherein the capillary further comprises an extension portion connected to at least one of the plurality of patterned portions at an edge of the base plate and extending in the first direction and the second direction.

9. The heat pipe of claim 8,
wherein a first end of the extension portion is connected to the first capillary portion, and
wherein a second end opposite to the first end of the extension portion is connected to the second capillary portion.

10. The heat pipe of claim 7, wherein the base plate comprises first to fourth areas partitioned by a first reference line passing through a center point of the base plate and extending in the first direction and a second reference line passing through the center point of the base plate and extending in the second direction, wherein the capillary is bent at the central portion of the base plate and at an edge of each of the first to fourth areas, or wherein the capillary is bent at the central portion of the base plate, an edge of the base plate, the first reference line, and the second reference line.

11. The heat pipe of claim 10, wherein the turn portion comprises:
a first turn portion connecting the first capillary portion and the second capillary portion in a same area among the first to fourth areas; and
a second turn portion connecting the first capillary portion and the second capillary portion in different areas among the first to fourth areas.

12. The heat pipe of claim 11,
wherein the first turn portion is bent at an edge of the base plate,
wherein the second turn portion is bent at the first reference line or the second reference line, and
wherein a curvature of the first turn portion is greater than a curvature of the second turn portion.

13. The heat pipe of claim 7, wherein the capillary further comprises a bridge portion passing through a center point of the base plate, extending in the first direction or the second direction, and connected to at least one of the plurality of patterned portions, optionally wherein the bridge portion is connected to the turn portion.

14. The heat pipe of claim 13, wherein the bridge portion comprises:
a first bridge portion passing through the center point of the base plate and being extended in the first direction; and
a second bridge portion passing through the center point of the base plate and extending in the second direction, optionally wherein the first bridge portion and the second bridge portion have different diameters.

15. An electronic device comprising:
a display panel comprising a pixel;
a power supply configured to provide power to the display panel; and
a heat pipe according to any one of the preceding claims configured to dissipate heat generated from the display panel.
